# EUROPEAN PATENT APPLICATION

(11) **EP 4 451 536 A1**
(43) Date of publication of application: **23.10.2024**
(21) Application number: 22923606.2
(22) Date of filing: 23.12.2022
(51) Int. Cl.: H02M 3/158

(54) **SWITCHED CAPACITOR CONVERTER (SC) AND ELECTRONIC DEVICE**

(30) Priority: 30.01.2022 CN 202210114727
(71) Applicant: Huawei Technologies Co., Ltd., Shenzhen, Guangdong 518129 (CN); Nanjing University of Aeronautics and Astronautics, Nanjing, Jiangsu 211106 (CN)
(72) Inventor: RUAN, Xinbo, Nanjing, Jiangsu 211106 (CN); YE, Gang, Shenzhen, Guangdong 518129 (CN); YAO, Kai, Nanjing, Jiangsu 211106 (CN); SHAO, Fanguang, Nanjing, Jiangsu 211106 (CN); HOU, Qinghui, Shenzhen, Guangdong 518129 (CN)
(74) Representative: Körber, Martin Hans
(86) International application number: PCT/CN2022/141582
(87) International publication number: WO 2023/142820

(57) **Abstract**

Embodiments of this application relate to the field of electronic technologies, and provide a switched capacitor circuit SC and an electronic device, so that a plurality of voltage step-down ratios can be flexibly switched. In the SC, a first end of a first switch circuit is connected to a power supply end, a second end of the first switch circuit is connected to a first end of a third capacitor, a third end of the first switch circuit is connected to a first end of a second switch circuit and a first end of a first capacitor, a fourth end of the first switch circuit is connected to a first end of a second capacitor, and a fifth end of the first switch circuit is connected to a first end of a third switch circuit, a first end of a fourth switch circuit, and a first end of a fourth capacitor; a second end of the third capacitor is connected to a second end of the second switch circuit, and a third end of the second switch circuit is connected to a ground; and a second end of the second capacitor is connected to a second end of the third switch circuit, a third end of the third switch circuit is connected to the ground, a second end of the first capacitor is connected to a second end of the fourth switch circuit, a third end of the fourth switch circuit is connected to the ground, and a second end of the fourth capacitor is connected to the ground.

## Description

This application claims priority to Chinese Patent Application No. 202210114727.7, filed with the China National Intellectual Property Administration on January 30, 2022 and entitled "SWITCHED CAPACITOR CIRCUIT SC AND ELECTRONIC DEVICE", which is incorporated herein by reference in its entirety.

### TECHNICAL FIELD

Embodiments of this application relate to the field of electronic technologies, and in particular, to a switched capacitor circuit SC and an electronic device.

### BACKGROUND

To implement wired or wireless fast charging for a terminal device such as a mobile phone, a watch, or a tablet computer, a high voltage that is two times (or four times) a battery voltage is output by using a power adapter or a wireless charging circuit, and then the high voltage is reduced to 1/2 (or 1/4) of the high voltage by using a switched capacitor circuit (switched capacitor converter, SC) in the terminal device, to charge a battery. In this way, using a high voltage to transmit electric energy at a same power can reduce a transmission current and reduce a line loss. In addition, the SC has a feature of open-loop high efficiency. A charging protocol controls an adapter or a wireless charging circuit to adjust a voltage or a current, so that a charging system of the entire terminal device is efficient, and heat consumption is reduced, to implement super fast charging.

At an initial stage of fast charging, the charging protocol usually controls the adapter or the wireless charging circuit to implement fast charging of the battery at a high charging power (for example, 60 W). In this case, the charging protocol controls the adapter or the wireless charger to output a relatively high voltage (for example, 20 V) to the SC. In this case, the SC works in a 4:1 voltage step-down mode, and converts the voltage of 20 V into 5 V to charge the battery. When the battery voltage or a battery capacity rises to a specific stage, or heat consumption of the charging power is excessively high, the charging power needs to be reduced to a lower charging power (for example, 40 W) by controlling the adapter or the wireless charger, and the voltage output by the adapter or the wireless charger to the SC is reduced to around 10 V In this case, to maintain an original charging current and maintain fast charging, the charging protocol controls the SC to reduce the input 10 V voltage to around 5 V in a 2:1 voltage step-down mode to continue charging the battery. Certainly, when the charging protocol controls the adapter or the wireless charger to further reduce the voltage, the SC needs to be controlled to further switch a voltage step-down mode, to ensure that an output voltage is continuously maintained at about 5 V In this way, effect of fast charging is ensured. Therefore, an SC that can flexibly switch a plurality of voltage step-down ratios needs to be provided.

### SUMMARY

Embodiments of this application provide a switched capacitor circuit SC and an electronic device, so that a plurality of voltage step-down ratios can be flexibly switched.

According to a first aspect, a switched capacitor circuit SC is provided. The switched capacitor circuit SC includes: a first switch circuit, a second switch circuit, a third switch circuit, a fourth switch circuit, a first capacitor, a second capacitor, a third capacitor, and a fourth capacitor. A first end of the first switch circuit is connected to a power supply end, a second end of the first switch circuit is connected to a first end of the third capacitor, a third end of the first switch circuit is connected to a first end of the second switch circuit and a first end of the first capacitor, a fourth end of the first switch circuit is connected to a first end of the second capacitor, and a fifth end of the first switch circuit is connected to a first end of the third switch circuit, a first end of the fourth switch circuit, and a first end of the fourth capacitor; a second end of the third capacitor is connected to a second end of the second switch circuit, and a third end of the second switch circuit is connected to a ground; and a second end of the second capacitor is connected to a second end of the third switch circuit, a third end of the third switch circuit is connected to the ground, a second end of the first capacitor is connected to a second end of the fourth switch circuit, a third end of the fourth switch circuit is connected to the ground, and a second end of the fourth capacitor is connected to the ground. In a first voltage step-down mode, the first switch circuit is configured to conduct the power supply end and the first end of the third capacitor and conduct the first end of the second capacitor and the first end of the fourth capacitor, the second switch circuit is configured to conduct the second end of the third capacitor and the first end of the first capacitor, the third switch circuit is configured to conduct the second end of the second capacitor and the ground, and the fourth switch circuit is configured to conduct the second end of the first capacitor and the first end of the fourth capacitor; or the first switch circuit is configured to conduct the first end of the third capacitor and the first end of the second capacitor and conduct the first end of the first capacitor and the first end of the fourth capacitor, the second switch circuit is configured to conduct the second end of the third capacitor and the ground, the third switch circuit is configured to conduct the second end of the second capacitor and the first end of the fourth capacitor, and the fourth switch circuit is configured to conduct the second end of the first capacitor and the ground. In a second voltage step-down mode, the first switch circuit is configured to conduct the power supply end and the first end of the first capacitor and conduct the first end of the second capacitor and the first end of the fourth capacitor, the third switch circuit is configured to conduct the second end of the second capacitor and the ground, and the fourth switch circuit is configured to conduct the second end of the first capacitor and the first end of the fourth capacitor; or the first switch circuit is configured to conduct the first end of the second capacitor and the power supply end and conduct the first end of the first capacitor and the first end of the fourth capacitor, the third switch circuit is configured to conduct the second end of the second capacitor and the first end of the fourth capacitor, and the fourth switch circuit is configured to conduct the second end of the first capacitor and the ground. In a third voltage step-down mode, the first switch circuit is configured to conduct the power supply end and the first end of the fourth capacitor.

In this way, when a 4:1 voltage step-down mode is implemented, in a first time period of one time periodicity, the first switch circuit conducts the power supply end and the first end of the third capacitor Cfly3 and conducts the first end of the second capacitor Cfly2 and the first end of the fourth capacitor Co, the second switch circuit conducts the second end of the third capacitor Cfly3 and the first end of the first capacitor Cfly1, the third switch circuit conducts the second end of the second capacitor Cfly2 and the ground GND, and the fourth switch circuit conducts the second end of the first capacitor Cfly1 and the first end of the fourth capacitor Co. The third capacitor Cfly3, the first capacitor Cfly1, and the fourth capacitor Co form a series connection structure, two ends of the series connection structure are respectively connected to the power supply end and the ground end GND, and the second capacitor Cfly2 and the fourth capacitor Co are connected in parallel. In this way, when a system is stable: Vin=Vcfly3+Vcfly1+Vo, and Vcfly2=Vo, where Vcfly3 is a voltage at two ends of the third capacitor Cfly3, Vcfly1 is a voltage at two ends of the first capacitor Cfly1, and V0 is a voltage at two ends of the fourth capacitor Co. In a second time period of one periodicity, the first switch circuit 31 conducts the first end of the third capacitor Cfly3 and the first end of the second capacitor Cfly2 and conducts the first end of the first capacitor Cfly1 and the first end of the fourth capacitor Co, the second switch circuit 32 conducts the second end of the third capacitor Cfly3 and the ground GND, and the third switch circuit 33 conducts the second end of the second capacitor Cfly2 and the first end of the fourth capacitor Co, and the fourth switch circuit conducts the second end of the first capacitor Cfly1 and the ground GND, where the first capacitor Cfly1 is connected in parallel to the fourth capacitor Co, and a serial connection structure of the second capacitor Cfly2 and the third capacitor Cfly3 is connected in parallel to the fourth capacitor Co. In this way, when the system is stable, Vcfly3=Vcfly2+Vo, where Vcfly2 is a voltage at two ends of the second capacitor Cfly2. In conclusion, it can be learned that Vin=4Vo, Vcfly3=2Vo, Vcfly2=Vo, and Vcfly1=Vo. Therefore, 4:1 voltage ratio conversion can be implemented.

When a 2:1 voltage step-down mode is implemented, in a first time period of one periodicity, the first switch circuit 31 conducts the power supply end and the first end of the first capacitor Cfly1 and conducts the first end of the second capacitor Cfly2 and the first end of the fourth capacitor Co, the third switch circuit conducts the second end of the second capacitor Cfly2 and the ground GND, and the fourth switch circuit 34 conducts the second end of the first capacitor Cfly1 and the first end of the fourth capacitor Co. The first capacitor Cfly1 and the fourth capacitor Co are connected in series between the power supply end and the ground GND, and the second capacitor Cfly2 and the fourth capacitor Co are connected in parallel. In this way, when the system is stable, Vin=Vcfly1+Vo, and Vo=Cfly2. In a second time period of one periodicity, the first switch circuit conducts the power supply end and the first end of the second capacitor Cfly2 and conducts the first end of the first capacitor Cflyl and the first end of the fourth capacitor Co, the third switch circuit conducts the second end of the second capacitor Cfly2 and the first end of the fourth capacitor Co, and the fourth switch circuit conducts the second end of the first capacitor Cfly1 and the ground GND. The second capacitor Cfly2 and the fourth capacitor Co are connected in series between the power supply end and the ground GND. The first capacitor Cfly1 and the fourth capacitor Co are connected in parallel. A current flow direction is shown by a dashed line arrow in the figure. In this way, when the system is stable, Vin=Vcfly1+Vo, and Vo=Cfly2. In conclusion, it can be learned that Vin=2Vo, Vcfly2=Vo, and Vcfly1=Vo. Therefore, 2:1 voltage ratio conversion can be implemented.

When a 1:1 voltage step-down mode is implemented, the first switch circuit 31 conducts the power supply end and the first end of the fourth capacitor Co. The fourth capacitor Co is connected in series between the power supply end and the ground GND. In this way, when the system is stable, Vin=Vo. In this way, 1:1 voltage ratio conversion can be implemented.

In conclusion, when the SC circuit works in different voltage step-down modes, voltage step-down is separately performed in a ratio of 4:1, 2:1, and 1:1 on a voltage at an input end and then a voltage is output at the two ends of the fourth capacitor Co to implement switching of a plurality of voltage step-down ratios.

In a possible implementation, the first switch circuit includes: a first switch, a second switch, a third switch, a fourth switch, and a fifth switch. A first end of the first switch is connected to the first end of the first switch circuit, and a second end of the first switch is connected to the second end of the first switch circuit; a first end of the second switch is connected to the second end of the first switch circuit, and a second end of the second switch is connected to the fourth end of the first switch circuit; a first end of the fourth switch is connected to the second end of the first switch circuit, and a second end of the fourth switch is connected to the third end of the first switch circuit; a first end of the third switch is connected to the fourth end of the first switch circuit, and a second end of the third switch is connected to the fifth end of the first switch circuit; and a first end of the fifth switch is connected to the third end of the first switch circuit, and a second end of the fifth switch is connected to the fifth end of the first switch circuit. In the first voltage step-down mode, in a first time period of one periodicity, the first switch and the third switch are in a turned-on state, and the second switch and the fifth switch are in a turned-off state; in a second time period of one periodicity, the first switch and the third switch are in a turned-off state, and the second switch and the fifth switch are in a turned-on state; and the fourth switch is in a turned-off state in one periodicity. In the second voltage step-down mode, in a first time period of one periodicity, the third switch and the fourth switch are in a turned-on state, and the second switch and the fifth switch are in a turned-off state; in a second time period of one periodicity, the third switch and the fourth switch are in a turned-off state, and the second switch and the fifth switch are in a turned-on state; the fourth switch is in a turned-off state in one periodicity; and the first switch is in a turned-on state in one periodicity. In the third voltage step-down mode, the first switch, the second switch, the third switch, the fourth switch, and the fifth switch are in a turned-on state.

In a possible implementation, the second switch circuit includes a sixth switch and a seventh switch. A first end of the sixth switch is connected to the first end of the second switch circuit, and a second end of the sixth switch is connected to the second end of the second switch circuit. A first end of the seventh switch is connected to the second end of the second switch circuit, and a second end of the seventh switch is connected to the third end of the second switch circuit. In the first voltage step-down mode, in the first time period of one periodicity, the sixth switch is in a turned-on state, and the seventh switch is in a turned-off state; and in the second time period of one periodicity, the sixth switch is in a turned-off state, and the seventh switch is in a turned-on state. In the second voltage step-down mode, the sixth switch and the seventh switch are in a turned-off state in one periodicity. In the third voltage step-down mode, the sixth switch and the seventh switch are in a turned-off state.

In a possible implementation, the third switch circuit includes an eighth switch and a ninth switch. A first end of the eighth switch is connected to the first end of the third switch circuit, and a second end of the eighth switch is connected to the second end of the third switch circuit. A first end of the ninth switch is connected to the second end of the third switch circuit, and a second end of the ninth switch is connected to the third end of the third switch circuit. In the first voltage step-down mode, in the first time period of one periodicity, the ninth switch is in a turned-on state, and the eighth switch is in a turned-off state; and in the second time period of one periodicity, the ninth switch is in a turned-off state, and the eighth switch is in a turned-on state. In the second voltage step-down mode, in the first time period of one periodicity, the ninth switch is in a turned-on state, and the eighth switch is in a turned-off state; and in the second time period of one periodicity, the ninth switch is in a turned-off state, and the eighth switch is in a turned-on state. In the third voltage step-down mode, the eighth switch and the ninth switch are in a turned-off state.

In a possible implementation, the fourth switch circuit includes a tenth switch and an eleventh switch. A first end of the tenth switch is connected to the first end of the fourth switch circuit, and a second end of the tenth switch is connected to the second end of the fourth switch circuit. A first end of the eleventh switch is connected to the second end of the fourth switch circuit, and a second end of the eleventh switch is connected to the third end of the fourth switch circuit. In the first voltage step-down mode, in the first time period of one periodicity, the tenth switch is in a turned-on state, and the eleventh switch is in a turned-off state; and in the second time period of one periodicity, the tenth switch is in a turned-off state, and the eleventh switch is in a turned-on state. In the second voltage step-down mode, in the first time period of one periodicity, the tenth switch is in a turned-on state, and the eleventh switch is in a turned-off state; and in a second time period of one periodicity, the tenth switch is in a turned-off state, and the eleventh switch is in a turned-on state. In the third voltage step-down mode, the tenth switch and the eleventh switch are in a turned-off state.

In this way, in a 4:1 voltage step-down mode, the first switch, the sixth switch, and the tenth switch are in a turned-on state in the first time period of one periodicity, and the third capacitor, the first capacitor, and the fourth capacitor are sequentially connected in a series relationship to form a current path; the third switch and the ninth switch are in a turned-on state, and the second capacitor and the fourth capacitor are connected in a series relationship to form another current path, and another switch is turned off. In the second time period of one periodicity, the second switch, the seventh switch, and the eighth switch are in a turned-on state, and the third capacitor, the second capacitor, and the fourth capacitor are sequentially connected in a series relationship to form a current path; and the fifth switch and the ninth switch are in a turned-on state, so that the first capacitor and the fourth capacitor are connected in a series relationship to form another current path, and another switch is turned off. In this case, two current paths are formed in each of the two time periods. In this way, there is only one current path on all switches in the turned-on state through which a current flows. Therefore, losses of the current on the switches are evenly distributed, and overall system efficiency of the SC can be effectively improved.

In this way, in a 2:1 voltage step-down mode, the first switch, the fourth switch, and the tenth switch are in a turned-on state in the first time period of one periodicity, and the first capacitor and the fourth capacitor are sequentially connected in a series relationship to form a current path; the third switch and the ninth switch are in a turned-on state, and the second capacitor and the fourth capacitor are connected in a series relationship to form another current path, and another switch is turned off; in the second time period of one periodicity, the first switch, the second switch, and the eighth switch are in a turned-on state, and the second capacitor, and the fourth capacitor are sequentially connected in a series relationship to form a current path; and the fifth switch and the eleventh switch are in a turned-on state, so that the first capacitor and the fourth capacitor are connected in a parallel relationship to form another current path, and another switch is turned off. In this case, two current paths are formed in each of the two time periods. In this way, there is only one current path on all switches in the turned-on state through which a current flows. Therefore, losses of the current on the switches are evenly distributed, and overall system efficiency of the SC can be effectively improved. In addition, in the 2:1 voltage step-down mode, the first capacitor and the fourth capacitor are connected in series in the first time period, and the first capacitor and the second capacitor are connected in series in the second time period, to form an interleaved parallel structure, to provide more current paths for the power supply end, and effectively reduce power consumption.

In the 1:1 voltage step-down mode, the first switch, the second switch, and the third switch are in a turned-on state, and the fourth capacitor is directly connected to the power supply end to form a current path; the first switch, the fourth switch, and the fifth switch are in a turned-on state, and the fourth capacitor is directly connected to the power supply end to form another current path. In this way, because the current path formed by the first switch, the second switch, and the third switch is connected in parallel to the current path formed by the first switch, the fourth switch, and the fifth switch, so that resistance on a charging path of the fourth circuit is reduced, power consumption can be effectively reduced, and efficiency of the SC can be improved.

In a possible implementation, each switch includes one switch transistor, or each switch includes two or more switch transistors connected in parallel. Each switch may alternatively use two or more switch transistors connected in parallel, to reduce resistance when the switch is turned on, to improve system efficiency.

According to a second aspect, a chip is provided. The chip includes: a first switch circuit, a second switch circuit, a third switch circuit, and a fourth switch circuit. A first end of the first switch circuit is connected to a power supply end, a second end of the first switch circuit is configured to connect to a first end of a third capacitor, a third end of the first switch circuit is connected to a first end of the second switch circuit, the third end of the first switch circuit is further configured to connect to a first end of a first capacitor, a fourth end of the first switch circuit is configured to connect to a first end of a second capacitor, and a fifth end of the first switch circuit is connected to a first end of the third switch circuit and a first end of the fourth switch circuit, and the fifth end of the first switch circuit is further configured to connect to a first end of a fourth capacitor; a second end of the second switch circuit is configured to connect to a second end of the third capacitor, and a third end of the second switch circuit is connected to a ground; a second end of the third switch circuit is configured to connect to a second end of the second capacitor, and a third end of the third switch circuit is connected to the ground; and a second end of the fourth switch circuit is configured to connect to a second end of the first capacitor, a third end of the fourth switch circuit is connected to the ground, and a second end of the fourth capacitor is connected to the ground. In a first voltage step-down mode, the first switch circuit is configured to conduct the power supply end and the first end of the third capacitor and conduct the first end of the second capacitor and the first end of the fourth capacitor, the second switch circuit is configured to conduct the second end of the third capacitor and the first end of the first capacitor, the third switch circuit is configured to conduct the second end of the second capacitor and the ground, and the fourth switch circuit is configured to conduct the second end of the first capacitor and the first end of the fourth capacitor; or the first switch circuit is configured to conduct the first end of the third capacitor and the first end of the second capacitor and conduct the first end of the first capacitor and the first end of the fourth capacitor, the second switch circuit is configured to conduct the second end of the third capacitor and the ground, the third switch circuit is configured to conduct the second end of the second capacitor and the first end of the fourth capacitor, and the fourth switch circuit is configured to conduct the second end of the first capacitor and the ground. In a second voltage step-down mode, the first switch circuit is configured to conduct the power supply end and the first end of the first capacitor and conduct the first end of the second capacitor and the first end of the fourth capacitor, the third switch circuit is configured to conduct the second end of the second capacitor and the ground, and the fourth switch circuit is configured to conduct the second end of the first capacitor and the first end of the fourth capacitor; or the first switch circuit is configured to conduct the first end of the second capacitor and the power supply end and conduct the first end of the first capacitor and the first end of the fourth capacitor, the third switch circuit is configured to conduct the second end of the second capacitor and the first end of the fourth capacitor, and the fourth switch circuit is configured to conduct the second end of the first capacitor and the ground. In a third voltage step-down mode, the first switch circuit is configured to conduct the power supply end and the first end of the fourth capacitor.

In a possible implementation, the first switch circuit includes: a first switch, a second switch, a third switch, a fourth switch, and a fifth switch. A first end of the first switch is connected to the first end of the first switch circuit, and a second end of the first switch is connected to the second end of the first switch circuit; a first end of the second switch is connected to the second end of the first switch circuit, and a second end of the second switch is connected to the fourth end of the first switch circuit; a first end of the fourth switch is connected to the second end of the first switch circuit, and a second end of the fourth switch is connected to the third end of the first switch circuit; a first end of the third switch is connected to the fourth end of the first switch circuit, and a second end of the third switch is connected to the fifth end of the first switch circuit; and a first end of the fifth switch is connected to the third end of the first switch circuit, and a second end of the fifth switch is connected to the fifth end of the first switch circuit. In the first voltage step-down mode, in a first time period of one periodicity, the first switch and the third switch are in a turned-on state, and the second switch and the fifth switch are in a turned-off state; in a second time period of one periodicity, the first switch and the third switch are in a turned-off state, and the second switch and the fifth switch are in a turned-on state; and the fourth switch is in a turned-off state in one periodicity. In the second voltage step-down mode, in a first time period of one periodicity, the third switch and the fourth switch are in a turned-on state, and the second switch and the fifth switch are in a turned-off state; in a second time period of one periodicity, the third switch and the fourth switch are in a turned-off state, and the second switch and the fifth switch are in a turned-on state; the fourth switch is in a turned-off state in one periodicity; and the first switch is in a turned-on state in one periodicity. In the third voltage step-down mode, the first switch, the second switch, the third switch, the fourth switch, and the fifth switch are in a turned-on state.

In a possible implementation, the second switch circuit includes a sixth switch and a seventh switch. A first end of the sixth switch is connected to the first end of the second switch circuit, and a second end of the sixth switch is connected to the second end of the second switch circuit. A first end of the seventh switch is connected to the second end of the second switch circuit, and a second end of the seventh switch is connected to the third end of the second switch circuit. In the first voltage step-down mode, in the first time period of one periodicity, the sixth switch is in a turned-on state, and the seventh switch is in a turned-off state; and in the second time period of one periodicity, the sixth switch is in a turned-off state, and the seventh switch is in a turned-on state. In the second voltage step-down mode, the sixth switch and the seventh switch are in a turned-off state. In the third voltage step-down mode, the sixth switch and the seventh switch are in a turned-off state.

In a possible implementation, the third switch circuit includes an eighth switch and a ninth switch. A first end of the eighth switch is connected to the first end of the third switch circuit, and a second end of the eighth switch is connected to the second end of the third switch circuit. A first end of the ninth switch is connected to the second end of the third switch circuit, and a second end of the ninth switch is connected to the third end of the third switch circuit. In the first voltage step-down mode, in the first time period of one periodicity, the ninth switch is in a turned-on state, and the eighth switch is in a turned-off state; and in the second time period of one periodicity, the ninth switch is in a turned-off state, and the eighth switch is in a turned-on state. In the second voltage step-down mode, in the first time period of one periodicity, the ninth switch is in a turned-on state, and the eighth switch is in a turned-off state; in the second time period of one periodicity, the ninth switch is in a turned-off state, and the eighth switch is in a turned-on state. In the third voltage step-down mode, the eighth switch and the ninth switch are in a turned-off state.

In a possible implementation, the fourth switch circuit includes a tenth switch and an eleventh switch. A first end of the tenth switch is connected to the first end of the fourth switch circuit, and a second end of the tenth switch is connected to the second end of the fourth switch circuit. A first end of the eleventh switch is connected to the second end of the fourth switch circuit, and a second end of the eleventh switch is connected to the third end of the fourth switch circuit. In the first voltage step-down mode, in the first time period of one periodicity, the tenth switch is in a turned-on state, and the eleventh switch is in a turned-off state; and in the second time period of one periodicity, the tenth switch is in a turned-off state, and the eleventh switch is in a turned-on state. In the second voltage step-down mode, in the first time period of one periodicity, the tenth switch is in a turned-on state, and the eleventh switch is in a turned-off state; in a second time period of one periodicity, the tenth switch is in a turned-off state, and the eleventh switch is in a turned-on state. In the third voltage step-down mode, the tenth switch and the eleventh switch are in a turned-off state.

In a possible implementation, each switch includes one switch transistor, or each switch includes two or more switch transistors connected in parallel.

For technical effect implemented in the second aspect, refer to the description in the first aspect or any possible implementation. Details are not described herein again.

According to a third aspect, an electronic device is provided. The electronic device includes the SC according to any one of the first aspect or the possible implementations of the first aspect, or includes the chip according to any one of the second aspect or the possible implementations of the second aspect.

For technical effect implemented in the third aspect, refer to the description in the first aspect or any possible implementation. Details are not described herein again.

In a possible implementation, the electronic device further includes a wireless charging coil, a receiver circuit, and a battery. The wireless charging coil is connected to the receiver circuit, the receiver circuit is connected to a power supply end of the SC or the chip, and the battery is connected in parallel to the fourth capacitor. In this way, a wireless charging manner is implemented.

In a possible implementation, the electronic device further includes a USB interface and a battery. The USB interface is connected to a power supply end of the SC or the chip, and the battery is connected in parallel to the fourth capacitor. In this way, a wired charging manner is implemented.

In a possible implementation, an over voltage protection circuit is further provided between the USB interface and the power supply end of the SC or the chip, and the over voltage protection circuit is configured to disconnect the power supply end of the SC or the chip from the USB interface when detecting that a voltage connected to the USB interface exceeds a threshold voltage. In this way, damage to the SC circuit or the chip and the battery is avoided when the voltage received by the USB interface is excessively high.

### BRIEF DESCRIPTION OF DRAWINGS

FIG. 1 is a schematic diagram of a structure of an electronic device according to an embodiment of this application;
FIG. 2 is a schematic diagram of a connection relationship of an SC according to an embodiment of this application;
FIG. 3 is a schematic diagram of a structure of an SC according to an embodiment of this application;
FIG. 4 is an equivalent circuit 1 of an SC according to an embodiment of this application;
FIG. 5 is an equivalent circuit 2 of an SC according to an embodiment of this application;
FIG. 6 is an equivalent circuit 3 of an SC according to an embodiment of this application;
FIG. 7 is an equivalent circuit 4 of an SC according to an embodiment of this application;
FIG. 8 is an equivalent circuit 5 of an SC according to an embodiment of this application;
FIG. 9 is a schematic diagram of a structure of an SC according to another embodiment of this application;
FIG. 10 is a schematic diagram 1 of control signal of switches of an SC according to an embodiment of this application;
FIG. 11 is a schematic diagram 1 of a current direction of an SC according to an embodiment of this application;
FIG. 12 is a schematic diagram 2 of a current direction of an SC according to an embodiment of this application;
FIG. 13 is a schematic diagram of a structure of an SC according to still another embodiment of this application;
FIG. 14 is a schematic diagram 2 of control signals of switches of an SC according to an embodiment of this application;
FIG. 15 is a schematic diagram 3 of a current direction of an SC according to an embodiment of this application;
FIG. 16 is an equivalent circuit 6 of an SC according to an embodiment of this application;
FIG. 17 is a schematic diagram 4 of a current direction of an SC according to an embodiment of this application;
FIG. 18 is an equivalent circuit 7 of an SC according to an embodiment of this application;
FIG. 19 is a schematic diagram of a structure of an SC according to yet another embodiment of this application;
FIG. 20 is a schematic diagram 3 of control signal of switches of an SC according to an embodiment of this application;
FIG. 21 is a schematic diagram 5 of a current direction of an SC according to an embodiment of this application;
FIG. 22 is an equivalent circuit 8 of an SC according to an embodiment of this application;
FIG. 23 is a schematic diagram 6 of a current direction of an SC according to an embodiment of this application;
FIG. 24 is an equivalent circuit 9 of an SC according to an embodiment of this application;
FIG. 25 is a schematic diagram 4 of control signal of switches of an SC according to an embodiment of this application;
FIG. 26 is a schematic diagram 7 of a current direction of an SC according to an embodiment of this application;
FIG. 27 is a schematic diagram 8 of a current direction of an SC according to an embodiment of this application;
FIG. 28 is a schematic diagram 5 of control signal of switches of an SC according to an embodiment of this application;
FIG. 29 is a schematic diagram 9 of a current direction of an SC according to an embodiment of this application;
FIG. 30 is an equivalent circuit 10 of an SC according to an embodiment of this application;
FIG. 31 is a schematic diagram 10 of a current direction of an SC according to an embodiment of this application;
FIG. 32 is an equivalent circuit 11 of an SC according to an embodiment of this application;
FIG. 33 is a schematic diagram 6 of control signal of switches of an SC according to an embodiment of this application;
FIG. 34 is a schematic diagram 11 of a current direction of an SC according to an embodiment of this application;
FIG. 35 is an equivalent circuit 12 of an SC according to an embodiment of this application;
FIG. 36 is a schematic diagram 12 of a current direction of an SC according to an embodiment of this application;
FIG. 37 is an equivalent circuit 13 of an SC according to an embodiment of this application;
FIG. 38 is a schematic diagram 13 of a current direction of an SC according to an embodiment of this application;
FIG. 39 is a schematic diagram 14 of a current direction of an SC according to an embodiment of this application;
FIG. 40 is a schematic diagram 15 of a current direction of an SC according to an embodiment of this application; and
FIG. 41 is a schematic diagram of a structure of a chip according to an embodiment of this application.

### DESCRIPTION OF EMBODIMENTS

The following clearly and completely describes the technical solutions in embodiments of this application with reference to the accompanying drawings. Apparently, the described embodiments are merely some but not all of the embodiments of this application. All other embodiments obtained by persons of ordinary skill in the art based on the embodiments provided in this application shall fall within the protection scope of this application.

Unless otherwise required by the context, throughout this specification and claims, the term "include (include)" and its other forms such as a third person singular form "includes (includes)" and a present participle form "including (including)" are interpreted as "open and inclusive", that is, "include, but not limited to". In the description of this specification, the terms such as "one embodiment (one embodiment)", "some embodiments (some embodiments)", "example embodiments (example embodiments)", "example (example)", "specific example (specific example)", or "some examples (some examples)" are intended to indicate that a specific feature, structure, material, or characteristic related to the embodiment or example is included in at least one embodiment or example of this application. The schematic representations of the foregoing terms do not necessarily refer to a same embodiment or example. Moreover, the particular feature, structure, material, or characteristic may be included in any one or more embodiments or examples in any appropriate manner.

The terms "first" and "second" mentioned below are merely intended for a purpose of description, and shall not be understood as an indication or implication of relative importance or implicit indication of the number of indicated technical features. Therefore, a feature defined with "first" or "second" may explicitly or implicitly include one or more features. In the descriptions of embodiments of this application, unless otherwise specified, "a plurality of" means two or more than two. In addition, the use of "based on" means openness and inclusiveness, because a process, a step, a calculation, or another action "based on" one or more conditions or values may be based in practice on additional conditions or beyond the values described.

The following describes technical solutions of this application with reference to accompanying drawings.

An SC provided in embodiments of this application may be applied to a mobile phone, a tablet computer, a notebook computer, an ultra-mobile personal computer (ultra-mobile personal computer, UMPC), a handheld computer, a netbook, a personal digital assistant (personal digital assistant, PDA), a wearable electronic device, a virtual reality device, or another electronic device. This is not limited in embodiments of this application.

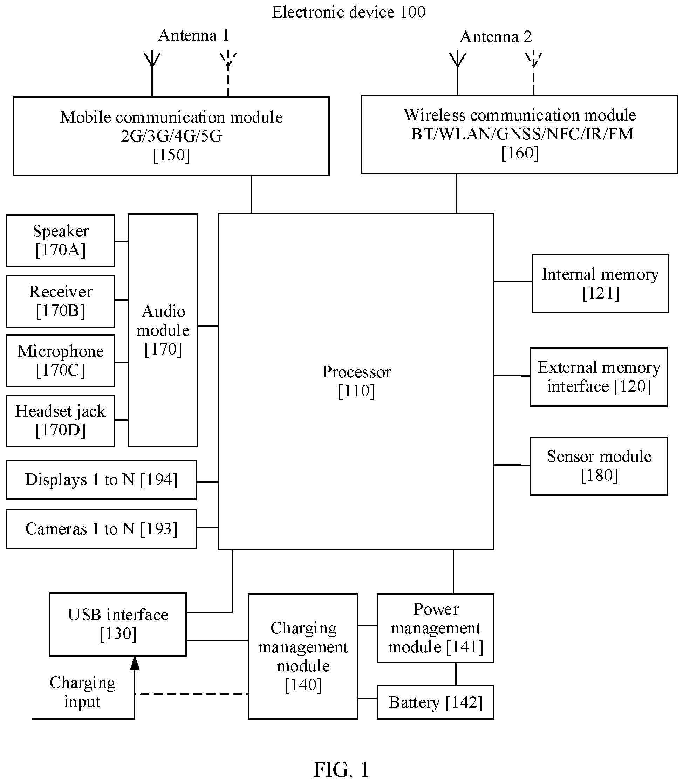

For example, FIG. 1 is a schematic diagram of a structure of an electronic device 100.

An electronic device 100 may include a processor 110, an external memory interface 120, an internal memory 121, a universal serial bus (universal serial bus, USB) interface 130, a charging management module 140, a power management module 141, a battery 142, an antenna 1, an antenna 2, a mobile communication module 150, a wireless communication module 160, an audio module 170, a speaker 170A, a receiver 170B, a microphone 170C, a headset jack 170D, a sensor module 180, a camera 193, a display 194, and the like.

It may be understood that the structure shown in this embodiment of the present invention does not constitute a specific limitation on the electronic device 100. In some other embodiments of this application, the electronic device 100 may include more or fewer components than those shown in the figure, or some components may be combined, or some components may be split, or different component arrangements may be used. The components shown in the figure may be implemented in hardware, software, or a combination of software and hardware.

The processor 110 may include one or more processing units. For example, the processor 110 may include an application processor (application processor, AP), a modem processor, a graphics processing unit (graphics processing unit, GPU), an image signal processor (image signal processor, ISP), a controller, a video codec, a digital signal processor (digital signal processor, DSP), a baseband processor, and/or a neural-network processing unit (neural-network processing unit, NPU). Different processing units may be independent components, or may be integrated into one or more processors.

A memory may be further disposed in the processor 110, and is configured to store instructions and data. In some embodiments, the memory in the processor 110 is a cache memory. The memory may store instructions or data that has been recently used or cyclically used by the processor 110. If the processor 110 needs to use the instruction or the data again, the processor 110 may directly invoke the instruction or the data from the memory. This avoids repeated access, reduces waiting time of the processor 110, and improves system efficiency.

In some embodiments, the processor 110 may include one or more interfaces. The interface may include an inter-integrated circuit (inter-integrated circuit, I2C) interface, an inter-integrated circuit sound (inter-integrated circuit sound, I2S) interface, a pulse code modulation (pulse code modulation, PCM) interface, a universal asynchronous receiver/transmitter (universal asynchronous receiver/transmitter, UART) interface, a mobile industry processor interface (mobile industry processor interface, MIPI), a general-purpose input/output (general-purpose input/output, GPIO) interface, a subscriber identity module (subscriber identity module, SIM) interface, a universal serial bus (universal serial bus, USB) interface, and/or the like.

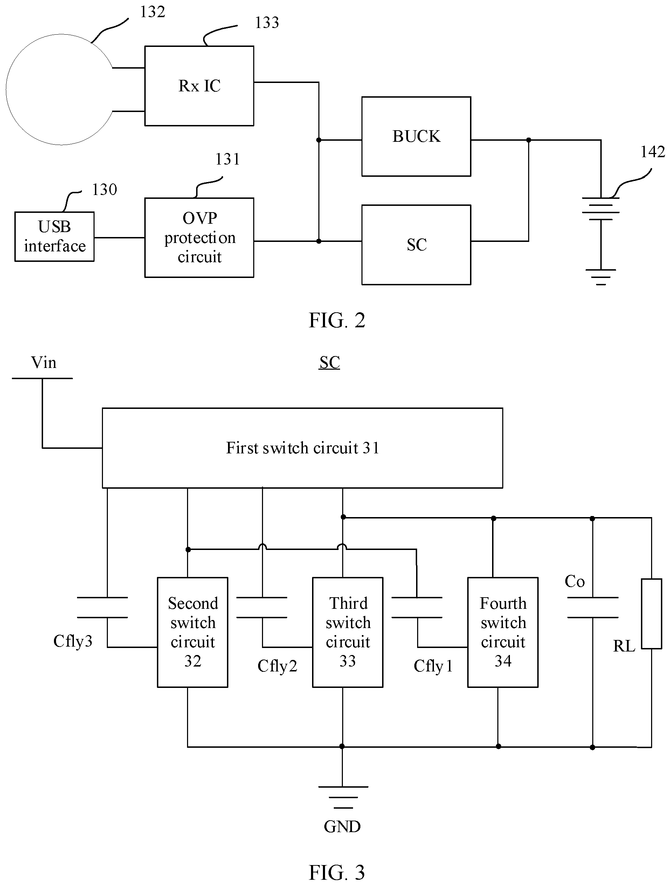

The charging management module 140 is configured to receive charging input from the charger. The charger may be a wireless charger or a wired charger (or an adapter). In some embodiments of wired charging, the charging management module 140 may receive a charging input from the wired charger through the USB interface 130. In some embodiments of wireless charging, the charging management module 140 may receive a wireless charging input by using a wireless charging coil of the electronic device 100. The charging management module 140 supplies power to the electronic device by using the power management module 141 while charging the battery 142. Specifically, refer to FIG. 2. The charging management module 140 may be specifically connected to the USB interface 130 by using an over-voltage protection (over voltage protection, OVP) protection circuit 131. When detecting that a voltage connected to the USB interface 130 is excessively high (exceeding a threshold voltage), the OVP protection circuit 131 may actively disconnect the charging management module 140 from the USB interface 130. For another example, refer to FIG. 2. The charging management module 140 is specifically connected to a wireless charging coil 132 through a receiver integrated circuit (receive integrated circuit, Rx IC) 133. Refer to FIG. 2. In addition, to implement common charging or fast charging on the battery. The charging management module 140 may include an SC configured to perform fast charging on the battery and a voltage step-down conversion circuit (for example, a BUCK) configured to perform common normal charging on the battery. The SC and the BUCK are connected to the USB interface 130 through the OVP protection circuit 131, and are connected to the wireless charging coil 132 through the Rx IC 133. The processor 110 or the charging management module 140 may detect, based on a charging protocol, charging by the BUCK or the SC for the battery. Generally, the SC and the BUCK are usually voltage step-down conversion circuits with a fixed voltage step-down ratio. For example, when detecting, based on the charging protocol, a fact that a voltage on an input side of the SC and the BUCK is 5 V, the processor 110 or the charging management module 140 controls the BUCK to convert the voltage of 5 V to a voltage 2 V that is slightly higher than a battery voltage, and then charges the battery, or when detecting, based on the charging protocol, a fact that a voltage on the input side of the SC and the BUCK is 20 V, which is determined as a fast charging scenario, the processor 110 or the charging management module 140 controls the SC to convert a voltage of 20 V into a voltage around the battery voltage, and then charge the battery. Certainly, when the battery voltage or a battery capacity rises to a specific stage, or heat consumption of a charging power is excessively high, the charging power needs to be reduced to a lower charging power (for example, 40 W) by controlling an adapter or a wireless charger, and a voltage output by the adapter or the wireless charger to the SC is reduced to around 10 V In this case, to maintain an original charging current and maintain fast charging, the charging protocol controls the SC to reduce the input 10 V voltage to around 5 V in a 2:1 voltage step-down mode to continue charging the battery. Certainly, when the charging protocol controls the adapter or the wireless charger to further reduce the voltage, the SC needs to be controlled to further switch a voltage step-down mode, to ensure that an output voltage is continuously maintained at about 5 V In this way, effect of fast charging is ensured. The following examples mainly describe a specific structure of the SC.

The power management module 141 is connected to the battery 142, the charging management module 140, and the processor 110. The power management module 141 receives an input from the battery 142 and/or the charging management module 140, and supplies power to the processor 110, the internal memory 121, the display 194, the camera 193, the wireless communication module 160, and the like. The power management module 141 may be further configured to monitor parameters such as a battery capacity, a battery cycle count, and a battery health status (electric leakage or impedance). In some other embodiments, the power management module 141 may alternatively be disposed in the processor 110. In some other embodiments, the power management module 141 and the charging management module 140 may also be provided in a same device.

A wireless communication function of the electronic device 100 may be implemented by using the antenna 1, the antenna 2, the mobile communication module 150, the wireless communication module 160, the modem processor, the baseband processor, and the like.

The antenna 1 and the antenna 2 are configured to transmit and receive an electromagnetic wave signal. Each antenna in the electronic device 100 may be configured to cover one or more communication frequency bands. Different antennas may be further multiplexed to improve antenna utilization. For example, the antenna 1 may be multiplexed as a diversity antenna in a wireless local area network. In some other embodiments, the antennas may be used in combination with a tuning switch.

The mobile communication module 150 may provide a solution, applied to the electronic device 100, to wireless communication including 2G, 3G, 4G, 5G, and the like. The mobile communication module 150 may include one or more filters, a switch, a power amplifier, a low noise amplifier (low noise amplifier, LNA), and the like. The mobile communication module 150 may receive an electromagnetic wave through the antenna 1, perform processing such as filtering or amplification on the received electromagnetic wave, and transmit the electromagnetic wave to the modem processor for demodulation. The mobile communication module 150 may further amplify a signal modulated by the modem processor, and convert the signal into an electromagnetic wave for radiation through the antenna 1. In some embodiments, at least some functional modules of the mobile communication module 150 may be disposed in the processor 110. In some embodiments, at least some functional modules of the mobile communication module 150 may be disposed in a same device as at least some modules of the processor 110.

The modem processor may include a modulator and a demodulator. The modulator is configured to modulate a to-be-sent low-frequency baseband signal into a medium-high frequency signal. The demodulator is configured to demodulate a received electromagnetic wave signal into a low-frequency baseband signal. Then, the demodulator transmits the low-frequency baseband signal obtained through demodulation to the baseband processor for processing. The low-frequency baseband signal is processed by the baseband processor and then transmitted to the application processor. The application processor outputs a sound signal by using an audio device (which is not limited to the speaker 170A, the receiver 170B, or the like), or displays an image or a video by using the display 194. In some embodiments, the modem processor may be an independent device. In some other embodiments, the modem processor may be independent of the processor 110, and is disposed in a same device as the mobile communication module 150 or another functional module.

The wireless communication module 160 may provide a wireless communication solution that is applied to the electronic device 100, and that includes a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, an infrared (infrared, IR) technology, or the like. The wireless communication module 160 may be one or more components into which one or more communication processing modules are integrated. The wireless communication module 160 receives an electromagnetic wave by using the antenna 2, performs frequency modulation on and filters the electromagnetic wave signal, and sends a processed signal to the processor 110. The wireless communication module 160 may further receive a to-be-sent signal from the processor 110, perform frequency modulation and amplification on the signal, and convert the signal into an electromagnetic wave for radiation through the antenna 2.

In some embodiments, the antenna 1 and the mobile communication module 150 in the electronic device 100 are coupled, and the antenna 2 and the wireless communication module 160 in the electronic device 100 are coupled, so that the electronic device 100 can communicate with a network and another device by using a wireless communications technology. The wireless communications technology may include a global system for mobile communications (global system for mobile communications, GSM), a general packet radio service (general packet radio service, GPRS), code division multiple access (code division multiple access, CDMA), wideband code division multiple access (wideband code division multiple access, WCDMA), time-division code division multiple access (time-division code division multiple access, TD-SCDMA), long term evolution (long term evolution, LTE), BT, a GNSS, a WLAN, NFC, FM, an IR technology, and/or the like. The GNSS may include a global positioning system (global positioning system, GPS), a global navigation satellite system (global navigation satellite system, GLONASS), a BeiDou navigation satellite system (BeiDou navigation satellite system, BDS), a quasi-zenith satellite system (quasi-zenith satellite system, QZSS), and/or a satellite based augmentation system (satellite based augmentation system, SBAS).

The electronic device 100 implements a display function by using the GPU, the display 194, the application processor, and the like. The GPU is a microprocessor for image processing and is connected to the display 194 and the application processor. The GPU is configured to: perform mathematical and geometric computation, and render an image. The processor 110 may include one or more GPUs that execute program instructions to generate or change display information.

The display 194 is configured to display an image, a video, and the like. The display 194 includes a display panel. The display panel may be a liquid crystal display (liquid crystal display, LCD), an organic light-emitting diode (organic light-emitting diode, OLED), an active-matrix organic light-emitting diode (active-matrix organic light-emitting diode, AMOLED), a flexible light-emitting diode (flexible light-emitting diode, FLED), a mini-LED, a micro-LED, a micro-OLED, a quantum dot light-emitting diode (quantum dot-light emitting diode, QLED), or the like. In some embodiments, the electronic device 100 may include 1 or N displays 194, where N is a positive integer greater than 1.

The electronic device 100 may implement a shooting function through the ISP, the camera 193, the video codec, the GPU, the display 194, the application processor, and the like.

The ISP is configured to process data fed back by the camera 193. For example, during photographing, a shutter is enabled. Light is transferred to a photosensitive element of the camera through a lens, and an optical signal is converted into an electrical signal. The photosensitive element of the camera transmits the electrical signal to the ISP for processing, and the electrical signal is converted into an image visible to a naked eye. The ISP may further perform algorithm optimization on noise, brightness, and complexion of the image. The ISP may further optimize parameters such as exposure and a color temperature of a photographing scenario. In some embodiments, the ISP may be disposed in the camera 193.

The camera 193 is configured to capture a still image or a video. An optical image of an object is generated through a lens, and is projected onto a photosensitive element. The photosensitive element may be a charge coupled device (charge coupled device, CCD) or a complementary metal-oxide-semiconductor (complementary metal-oxide-semiconductor, CMOS) phototransistor. The light-sensitive element converts an optical signal into an electrical signal, and then transmits the electrical signal to the ISP to convert the electrical signal into a digital image signal. The ISP outputs the digital image signal to a DSP for processing. The DSP converts the digital image signal into an image signal in a standard format such as RGB or YUV. In some embodiments, the electronic device 100 may include 1 or N cameras 193, where N is a positive integer greater than 1.

The external memory interface 120 may be used to connect to an external storage card, for example, a micro SD card, to extend a storage capability of the electronic device 100. The external storage card communicates with the processor 110 through the external memory interface 120, to implement a data storage function. For example, files such as music and videos are stored in the external storage card.

The internal memory 121 may be configured to store one or more computer programs, and the one or more computer programs include instructions. The processor 110 may run the instructions stored in the internal memory 121, so that the electronic device 100 performs a method provided in some embodiments of this application, various functional applications, data processing, and the like. The internal memory 121 may include a program storage area and a data storage area. The program storage area may store an operating system. The program storage area may further store one or more applications (such as Gallery or Contacts). The data storage area may store data (for example, a photo and a contact) created during use of the electronic device 101, and the like. In addition, the internal memory 121 may include a high-speed random access memory, and may further include a non-volatile memory, such as one or more disk storage components, a flash memory device, or a universal flash storage (universal flash storage, UFS). In some other embodiments, the processor 110 runs the instructions stored in the internal memory 121 and/or the instructions stored in the memory disposed in the processor, so that the electronic device 100 performs the method provided in embodiments of this application, various functional applications, and data processing.

The electronic device 100 may implement audio functions through the audio module 170, the speaker 170A, the receiver 170B, the microphone 170C, the headset jack 170D, the application processor, and the like. The audio function includes, for example, music playing and sound recording.

The audio module 170 is configured to convert digital audio information into an analog audio signal for output, and is also configured to convert analog audio input into a digital audio signal. The audio module 170 may be configured to encode and decode an audio signal. In some embodiments, the audio module 170 may be disposed in the processor 110, or some functional modules of the audio module 170 are disposed in the processor 110.

The speaker 170A, also referred to as a "loudspeaker", is configured to convert an audio electrical signal into a sound signal. The electronic device 100 may be used to listen to music or answer a hands-free call through the speaker 170A.

The receiver 170B, also referred to as an "earpiece", is configured to convert an audio electrical signal into a sound signal. When a call is answered or voice information is received through the electronic device 100, the receiver 170B may be put close to a human ear for listening to a voice.

The microphone 170C, also referred to as a "mike" or a "mic", is configured to convert a sound signal into an electrical signal. When making a call or sending a voice message, a user may make a sound near the microphone 170C through the mouth, to enter a sound signal to the microphone 170C. One or more microphones 170C may be disposed in the electronic device 100. In some other embodiments, the electronic device 100 may be provided with two microphones 170C, and may further implement a noise reduction function in addition to collecting a sound signal. In some other embodiments, the electronic device 100 may alternatively be provided with three, four, or more microphones 170C, to collect a sound signal, implement noise reduction, identify a sound source, implement a directional recording function, and the like.

The headset jack 170D is configured to be connected to a wired headset. The headset jack 170D may be the USB interface 130, or may be a 3.5 mm open mobile terminal platform (open mobile terminal platform, OMTP) standard interface or cellular telecommunications industry association of the USA (cellular telecommunications industry association of the USA, CTIA) standard interface.

The sensor module 180 may include a pressure sensor, a gyroscope sensor, a barometric pressure sensor, a magnetic sensor, an acceleration sensor, a range sensor, an optical proximity sensor, a fingerprint sensor, a temperature sensor, a touch sensor, an ambient light sensor, a bone conduction sensor, and the like.

In addition, the electronic device may further include one or more components such as a button 190, a motor 191, an indicator 192, and a subscriber identification module (subscriber identification module, SIM) card interface 195. This is not limited in this embodiment of this application.

Based on the foregoing electronic device, an embodiment of this application provides an SC. Refer to FIG. 3. The SC includes a first switch circuit 31, a second switch circuit 32, a third switch circuit 33, a fourth switch circuit 34, a first capacitor Cfly1, a second capacitor Cfly2, a third capacitor Cfly3, and a fourth capacitor Co. A first end of the first switch circuit 31 is connected to a power supply end, and the power supply end is connected to a power adapter through a USB interface, or is connected to a wireless charging circuit, to provide an input voltage Vin for the SC. A second end of the first switch circuit 31 is connected to a first end of the third capacitor Cfly3. A third end of the first switch circuit 31 is connected to a first end of the second switch circuit 32 and a first end of the first capacitor fly1. A fourth end of the first switch circuit 31 is connected to a first end of the second capacitor Cfly. A fifth end of the first switch circuit 31 is connected to a first end of the third switch circuit 33 circuit, a first end of the fourth switch circuit 33, and a first end of the fourth capacitor Co. A second end of the third capacitor Cfly3 is connected to a second end of the second switch circuit 32, and a third end of the second switch circuit 32 is connected to a ground GND. A second end of the second capacitor Cfly2 is connected to a second end of the third switch circuit 33, a third end of the third switch circuit 33 is connected to the ground GND, a second end of the first capacitor Cfly1 is connected to a second end of the fourth switch circuit 34, a third end of the fourth switch circuit 34 is connected to the ground GND, and a second end of the fourth capacitor Co is connected to the ground GND. In this solution, the first capacitor Cfly1, the second capacitor Cfly2, and the third capacitor Cfly3 are flying capacitors, the fourth capacitor Co is used as an output capacitance (output capacitance), and a voltage at two ends of the fourth capacitor Co provides a stable power supply voltage for a load RL (in a mobile phone scenario, the load is a battery).

In a first voltage step-down mode, the first switch circuit 31 is configured to conduct the power supply end and the first end of the third capacitor Cfly3 and conduct the first end of the second capacitor Cfly2 and the first end of the fourth capacitor Co, the second switch circuit 32 is configured to conduct the second end of the third capacitor Cfly3 and the first end of the first capacitor Cfly1, the third switch circuit 33 is configured to conduct the second end of the second capacitor Cfly2 and the ground GND, and the fourth switch circuit 34 is configured to conduct the second end of the first capacitor Cfly1 and the first end of the fourth capacitor Co; or the first switch circuit 31 is configured to conduct the first end of the third capacitor Cfly3 and the first end of the second capacitor Cfly2 and conduct the first end of the first capacitor Cfly1 and the first end of the fourth capacitor Co, the second switch circuit 32 is configured to conduct the second end of the third capacitor Cfly3 and the ground GND, the third switch circuit 33 is configured to conduct the second end of the second capacitor Cfly2 and the first end of the fourth capacitor Co, and the fourth switch circuit 34 is configured to conduct the second end of the first capacitor Cfly1 and the ground GND.

In a second voltage step-down mode, the first switch circuit 31 is configured to conduct the power supply end and the first end of the first capacitor Cfly1 and conduct the first end of the second capacitor Cfly2 and the first end of the fourth capacitor Co, the third switch circuit 33 is configured to conduct the second end of the second capacitor Cfly2 and the ground GND, and the fourth switch circuit 34 is configured to conduct the second end of the first capacitor Cfly1 and the first end of the fourth capacitor Co; or the first switch circuit 31 is configured to conduct the first end of the second capacitor Cfly2 and the power supply end and conduct the first end of the first capacitor Cfly1 and the first end of the fourth capacitor Co, the third switch circuit 33 is configured to conduct the second end of the second capacitor Cfly2 and the first end of the fourth capacitor Co, and the fourth switch circuit 34 is configured to conduct the second end of the first capacitor Cfly1 and the ground GND.

In a third voltage step-down mode, the first switch circuit 31 is configured to conduct the power supply end and the first end of the fourth capacitor Co.

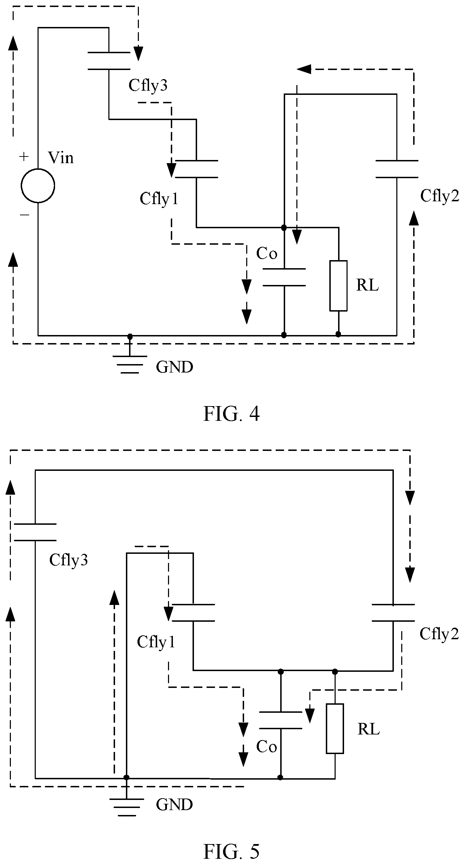

In this way, when a 4:1 voltage step-down mode is implemented, in a first time period of one time periodicity, the first switch circuit 31 conducts the power supply end and the first end of the third capacitor Cfly3 and conducts the first end of the second capacitor Cfly2 and the first end of the fourth capacitor Co, the second switch circuit 32 conducts the second end of the third capacitor Cfly3 and the first end of the first capacitor Cfly1, the third switch circuit 33 conducts the second end of the second capacitor Cfly2 and the ground GND, and the fourth switch circuit 34 conducts the second end of the first capacitor Cfly1 and the first end of the fourth capacitor Co, so that the capacitors are connected to form an equivalent circuit shown in FIG. 4. The third capacitor Cfly3, the first capacitor Cfly1, and the fourth capacitor Co form a series connection structure, and two ends of the series connection structure are respectively connected to the power supply end and the ground end GND. The second capacitor Cfly2 and the fourth capacitor Co are connected in parallel. A current flow direction is shown by a dashed line arrow in the figure. In this way, when a system is stable: Vm=Vcfly3 + Vcfly 1+Vo, and Vcfly2=Vo, where Vcfly3 is a voltage at two ends of the third capacitor Cfly3, Vcfly 1 is a voltage at two ends of the first capacitor Cfly1, and V0 is a voltage at two ends of the fourth capacitor Co. In a second time period of one periodicity, the first switch circuit 31 conducts the first end of the third capacitor Cfly3 and the first end of the second capacitor Cfly2 and conducts the first end of the first capacitor Cfly1 and the first end of the fourth capacitor Co, the second switch circuit 32 conducts the second end of the third capacitor Cfly3 and the ground GND, and the third switch circuit 33 conducts the second end of the second capacitor Cfly2 and the first end of the fourth capacitor Co, and the fourth switch circuit conducts the second end of the first capacitor Cfly1 and the ground GND, so that the capacitors are connected to form an equivalent circuit shown in FIG. 5. The first capacitor Cfly1 is connected in parallel to the fourth capacitor Co. A serial connection structure of the second capacitor Cfly2 and the third capacitor Cfly3 is connected in parallel to the fourth capacitor Co. A current flow direction is shown by a dashed line arrow in the figure. In this way, when the system is stable, Vcfly3=Vcfly2+Vo, where Vcfly2 is a voltage at two ends of the second capacitor Cfly2. In conclusion, it can be learned that Vin=4Vo, Vcfly3=2Vo, Vcfly2=Vo, and Vcfly1=V0. Therefore, 4:1 voltage ratio conversion can be implemented.

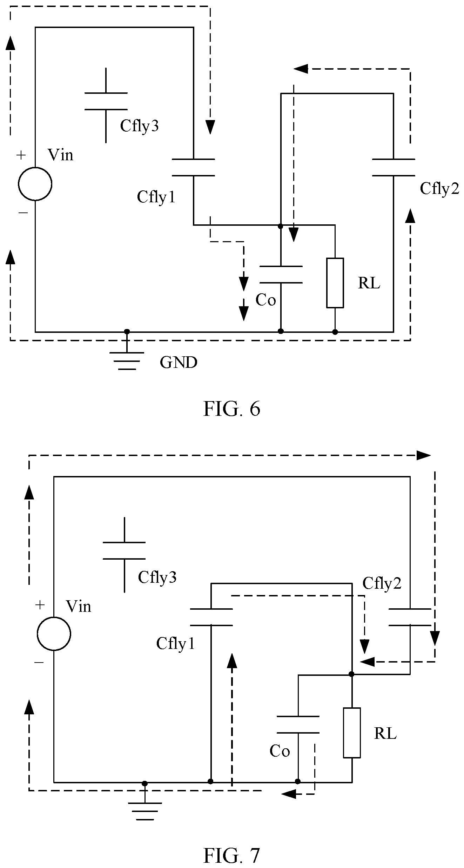

When a 2:1 voltage step-down mode is implemented, in a first time period of one periodicity, the first switch circuit 31 conducts the power supply end and the first end of the first capacitor Cfly1 and conducts the first end of the second capacitor Cfly2 and the first end of the fourth capacitor Co, the third switch circuit 33 conducts the second end of the second capacitor Cfly2 and the ground GND, and the fourth switch circuit 34 conducts the second end of the first capacitor Cfly1 and the first end of the fourth capacitor Co, so that the capacitors are connected to form an equivalent circuit shown in FIG. 6. The first capacitor Cfly1 and the fourth capacitor Co are connected in series between the power supply end and the ground GND. The second capacitor Cfly2 and the fourth capacitor Co are connected in parallel. A current flow direction is shown by a dashed arrow in the figure. In this way, when the system is stable, Vin=Vcfly1+Vo, and Vo=Cfly2. In a second time period of one periodicity, the first switch circuit 31 conducts the power supply end and the first end of the second capacitor Cfly2 and conducts the first end of the first capacitor Cfly1 and the first end of the fourth capacitor Co, the third switch circuit 33 conducts the second end of the second capacitor Cfly2 and the first end of the fourth capacitor Co, and the fourth switch circuit 34 conducts the second end of the first capacitor Cfly1 and the ground GND, so that the capacitors are connected to form an equivalent circuit shown in FIG. 7. The second capacitor Cfly2 and the fourth capacitor Co are connected in series between the power supply end and the ground GND. The first capacitor Cfly1 and the fourth capacitor Co are connected in parallel. A current flow direction is shown by a dashed arrow in the figure. In this way, when the system is stable, Vin=Vcfly2+Vo, and Vo=Cfly1. In conclusion, it can be learned that Vin=2Vo, Vcfly2=Vo, and Vcfly1=Vo. Therefore, 2:1 voltage ratio conversion can be implemented.

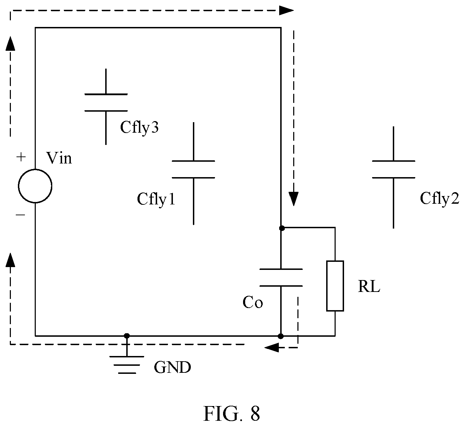

When a 1:1 voltage step-down mode is implemented, the first switch circuit 31 conducts the power supply end and the first end of the fourth capacitor Co, so that the capacitors are connected to form an equivalent circuit shown in FIG. 8. The fourth capacitor Co is connected in series between the power supply end and the ground GND. A current flow direction is shown by a dashed line arrow in the figure. In this way, when the system is stable, Vin=Vo. Therefore, 1:1 voltage ratio conversion can be implemented.

In conclusion, when the SC circuit works in different voltage step-down modes, voltage step-down is separately performed in a ratio of 4:1, 2:1, and 1:1 on a voltage at an input end and then a voltage is output at the two ends of the fourth capacitor Co to implement switching of a plurality of voltage step-down ratios.

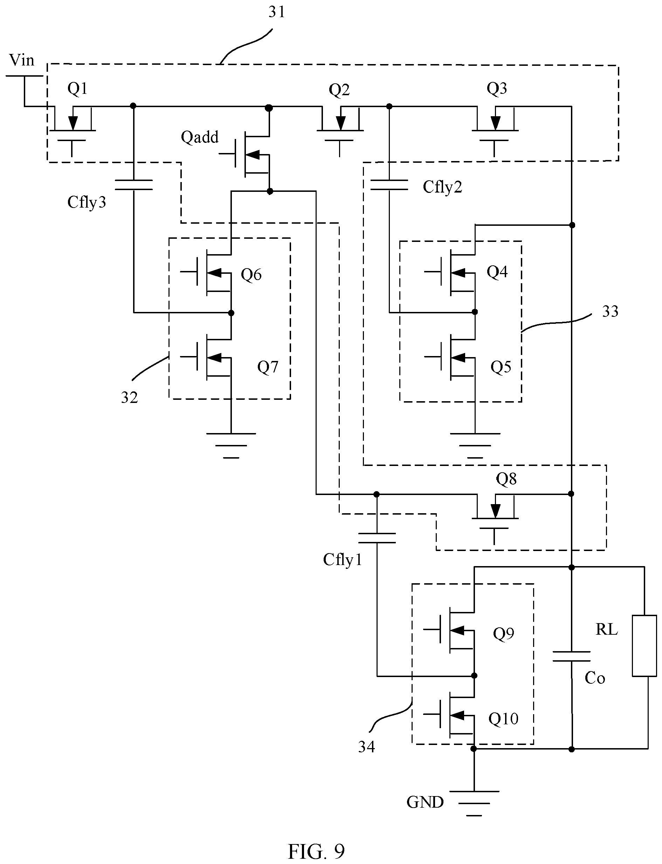

With reference to FIG. 9, the first switch circuit 31 includes switches Q1, Q2, Q3, Qadd, and Q8. A first end of the switch Q1 is connected to the first end of the first switch circuit 31, and a second end of the switch Q1 is connected to the second end of the first switch circuit 31. A first end of the switch Q2 is connected to the second end of the first switch circuit 31, and a second end of the switch Q2 is connected to the fourth end of the first switch circuit 31. A first end of the switch Qadd is connected to the second end of the first switch circuit 31, and a second end of the switch Qadd is connected to the third end of the first switch circuit 31. A first end of the switch Q3 is connected to the fourth end of the first switch circuit 31, and a second end of the switch Q3 is connected to the fifth end of the first switch circuit 31. A first end of the switch Q8 is connected to the third end of the first switch circuit 31, and a second end of the switch Q8 is connected to the fifth end of the first switch circuit 31.

The second switch circuit 32 includes a switch Q6 and a switch Q7. A first end of the switch Q6 is connected to the first end of the second switch circuit 32, and a second end of the switch Q6 is connected to the second end of the second switch circuit 32. A first end of the switch Q7 is connected to the second end of the second switch circuit 32, and a second end of the switch Q7 is connected to the third end of the second switch circuit 32.

The third switch circuit 33 includes a switch Q4 and a switch Q5. A first end of the switch Q4 is connected to the first end of the third switch circuit 33, and a second end of the switch Q4 is connected to the second end of the third switch circuit 33. A first end of the switch Q5 is connected to the second end of the third switch circuit 33, and a second end of the switch Q5 is connected to the third end of the third switch circuit 33.

The fourth switch circuit 34 includes a switch Q9 and a switch Q10. A first end of the switch Q9 is connected to the first end of the fourth switch circuit 34, and a second end of the switch Q9 is connected to the second end of the fourth switch circuit 34. A first end of the switch Q10 is connected to the second end of the fourth switch circuit 34, and a second end of the switch Q10 is connected to the third end of the fourth switch circuit 34.

The foregoing switches Q1 to Q10 and Qadd each include a control end. Under control of the control end, the switch may switch the two ends of the switch between a turned-on state and a turned-off state. The switch may be usually a switch transistor (briefly referred to as a switch transistor or transistor). In this embodiment of this application, the switch transistor may be a metal-oxide-semiconductor field-effect transistor (Metal-Oxide-Semiconductor Field-Effect Transistor, MOSFET). In addition, in the example shown in FIG. 9, each switch is implemented by using one switch transistor. It may be understood that, to reduce resistance when the switch is turned on, each switch may alternatively use two or more switch transistors connected in parallel. In this embodiment of this application, the switch transistor is classified into two types: N (negative, negative)-type transistor and P (positive, positive)-type transistor. The switch transistor includes a source (source), a drain (drain), and a gate (gate). By controlling a level of a gate input to the switch transistor, the switch transistor may be controlled to be conducted (turned on) or disconnected (turned off, cut off, or open). When the switch transistor is turned on, the source and the drain are conducted, and a turn-on current is generated. In addition, when levels of the gate of the transistor are different, magnitudes of the turn-on currents generated between the source and the drain are also different. When the switch transistor is turned off, the source and the drain are not conducted, and no current is generated. In this embodiment of this application, the gate of the switch transistor is also referred to as a control end, the source is referred to as a first end, and the drain is referred to as a second end; or the gate is referred to as a control end, the drain is referred to as a first end, and the source is referred to as a second end. In addition, the N-type transistor is turned on when a level of a control end is a high level, a first end and a second end are conducted, and a turn-on current is generated between the first end and the second end; and the N-type transistor is turned off when the level of the control end is a low level, the first end and the second end are not conducted, and no current is generated. The P-type transistor is turned on when a level of a control end is a low level, a first end and a second end are conducted, and a turn-on current is generated; and the P-type transistor is turned off when the level of the control end is a high level, the first end and the second end are not conducted, and no current is generated. For switch transistors used as switches in the following solutions, refer to descriptions herein.

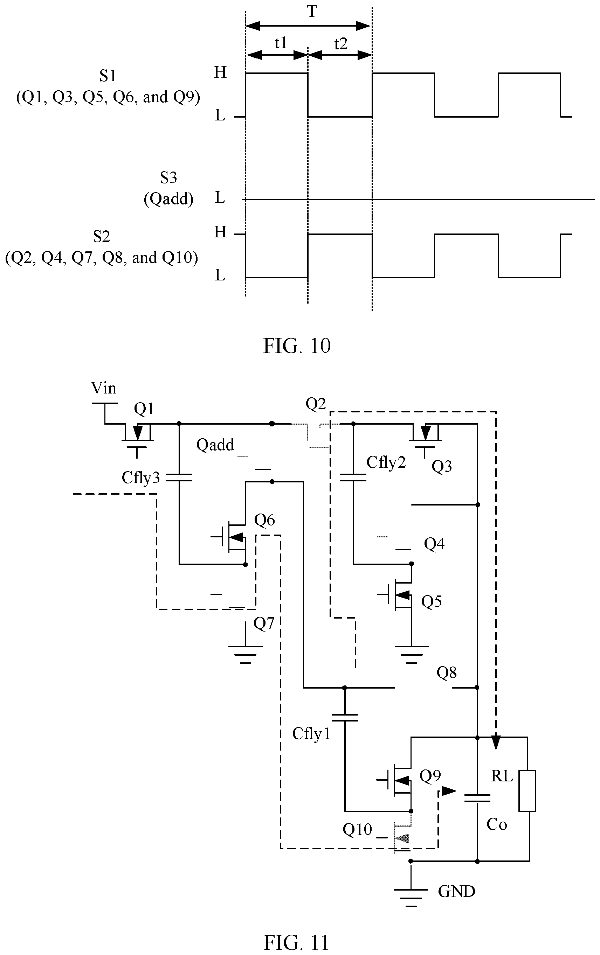

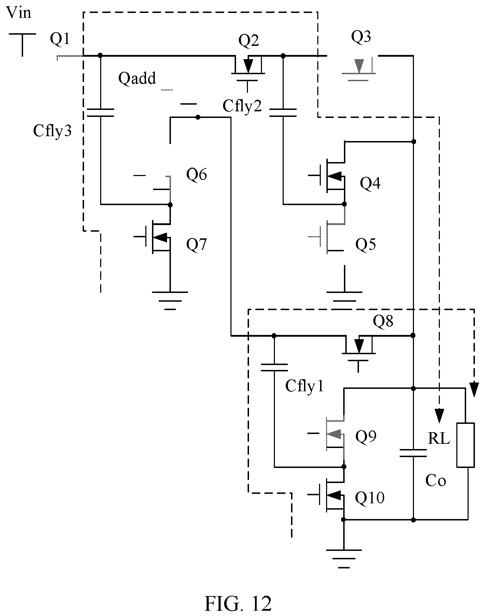

In addition, FIG. 10 is a time sequence diagram of control signals of the switches in FIG. 9 in one time periodicity T in a 4:1 voltage step-down mode. For example, each switch is turned on at a high level and is turned off at a low level. The switch Qadd (under control of S3) is in a turned-off state in the entire time periodicity T. In a first time period t1 of one time periodicity T, as shown in FIG. 11, the switches Q1, Q3, Q5, Q6, and Q9 are in a turned-on state under control of S1, and the switches Q2, Q4, Q7, Q8, and Q10 are in a turned-off state under control of S2, so that the capacitors are connected to form an equivalent circuit shown in FIG. 4. In a second time period t2, as shown in FIG. 12, the switches Q1, Q3, Q5, Q6, and Q9 are in a turned-off state under control of S1, and the switches Q2, Q4, Q7, Q8, and Q10 are in a turned-on state under control of S2, so that the capacitors are connected to form an equivalent circuit shown in FIG. 5. Therefore, 4:1 voltage ratio conversion can be implemented. In embodiments of this application, an example in which a switch is in a turned-on state when a control signal is a logical high level (H) and a switch is in a turned-off state when a control signal is a logical low level (L) is used for description.

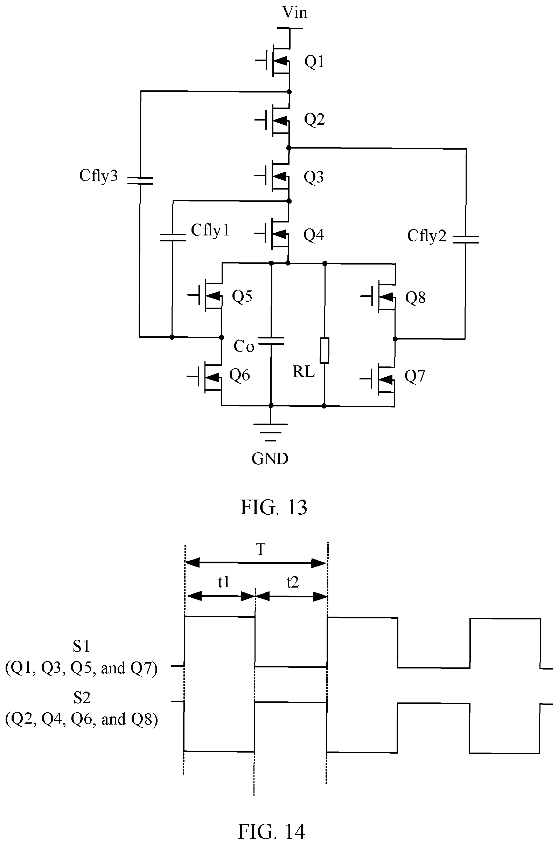

Refer to FIG. 13. A typical Dickson (Dickson)-based SC is further provided. The SC includes eight switches: Q1 to Q8, and four capacitors: Cfly1, Cfly1, Cfly3, and Co. The switches Q1, Q2, Q3, Q4 and the capacitor Co are sequentially connected in series between a power supply end (providing a power supply voltage Vin) and a ground GND, a series connection structure of the switches Q5 and Q6 is connected in parallel to the capacitor Co, a series connection structure of the switches Q8 and Q7 is connected in parallel to the capacitor Co, a series connection structure of the switches Q2, Q3, Q4, and Q5 is connected in parallel to the capacitor Cfly3, a series connection structure of the switches Q4 and Q5 is connected in parallel to the capacitor Cfly1, a series structure of the switches Q3, Q4, and Q8 is connected in parallel to the capacitor Cfly2, and a voltage output by two ends of the capacitor Co supplies power to a load RL.

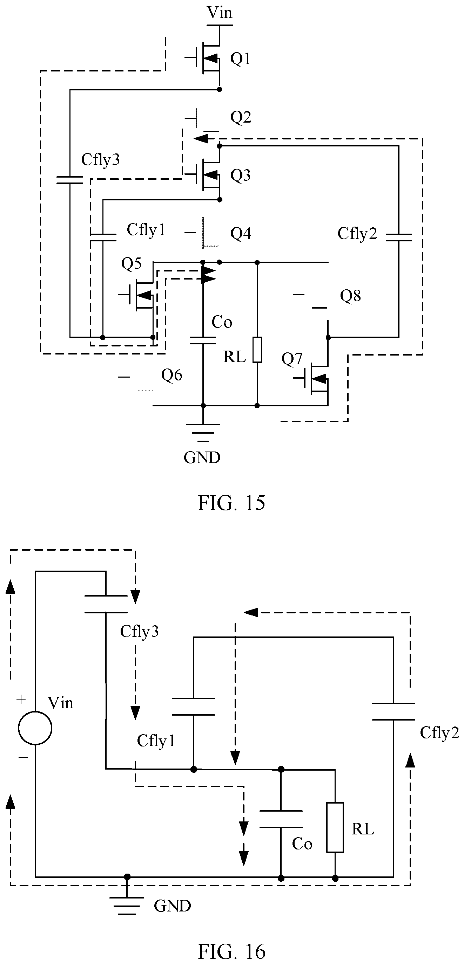

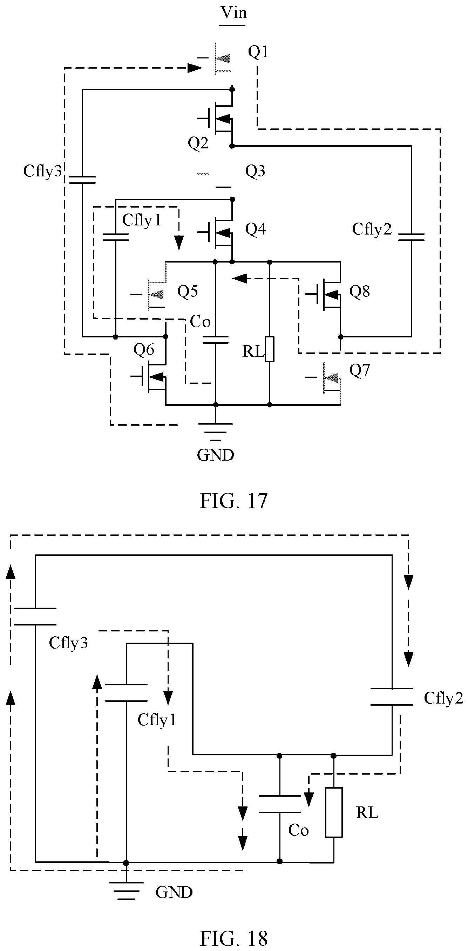

In addition, FIG. 14 is a time sequence diagram of control signals of the switches in FIG. 13 in one time periodicity T in a 4:1 voltage step-down mode. For example, each switch is turned on at a high level and is turned off at a low level. In a first time period t1 of one time periodicity T, as shown in FIG. 15, the switches Q1, Q3, Q5, and Q7 are in a turned-on state under control of S1, and the switches Q2, Q4, Q6, and Q8 are in a turned-off state under control of S2, so that the capacitors are connected to form an equivalent circuit shown in FIG. 16. The third capacitor Cfly3 and the fourth capacitor Co form a series structure, and two ends of the series structure are respectively connected to the power supply end and the ground end GND. A series structure formed by the first capacitor Cfly1 and the fourth capacitor Co is connected in parallel to the second capacitor Cfly2. A current flow direction is shown by a dashed arrow in the figure. In this way, when the system is stable, Vin=Vcfly3+Vo, and Vcfly2=Vcfly1+Vo. In a second time period t2, as shown in FIG. 17, the switches Q1, Q3, Q5, and Q7 are in a turned-off state under control of S1, and the switches Q2, Q4, Q7, and Q8 are in a turned-on state under control of S2, so that the capacitors are connected to form an equivalent circuit shown in FIG. 18. The first capacitor Cfly1 and the fourth capacitor CO form a series structure. A series structure formed by the second capacitor Cfly2 and the fourth capacitor CO is connected in parallel to the third capacitor Cfly3. A current flow direction is shown by a dashed arrow in the figure. In this way, when the system is stable, Vcfly3=Vcfly2+Vo, and Vcfly1=Vo. In conclusion, it can be learned that Vin=4Vo, Vcfly3=3Vo, Vcfly2=2Vo, and Vcfly1=Vo. Therefore, 4:1 voltage ratio conversion can be implemented.

With reference to circuit analysis of the SC provided in FIG. 9 in the 4:1 voltage step-down mode in FIG. 10 to FIG. 12 and circuit analysis of the SC provided in FIG. 13 in the 4:1 voltage step-down mode in FIG. 14 to FIG. 18, it can be learned that, in the 4:1 voltage step-down mode, because all currents of the SC provided in FIG. 13 need to pass through the switch Q5 (as shown in FIG. 15) in the time period t1 and all paths through which the currents flow need to pass through the switch Q6 (as shown in FIG. 17) in the time period t2, Q5 and Q6 have a larger current loss, and a large amount of heat is generated especially in a high current scenario, resulting in low efficiency. However, in the SC provided in FIG. 9, each switch passes through only one path through which a current flows. Therefore, losses of the currents on the switches are evenly distributed, and overall system efficiency is effectively improved compared with the SC provided in FIG. 13. In addition, in the 4:1 voltage step-down mode, Cfly3 in the SC provided in FIG. 13 requires a withstand voltage value of Vcfly3=3Vo, but Cfly3 in the SC provided in FIG. 9 requires a withstand voltage value of Vcfly3=2Vo. A higher withstand voltage required by Cfly3 indicates a lower energy density per unit volume of the capacitor and a lower conversion power density.

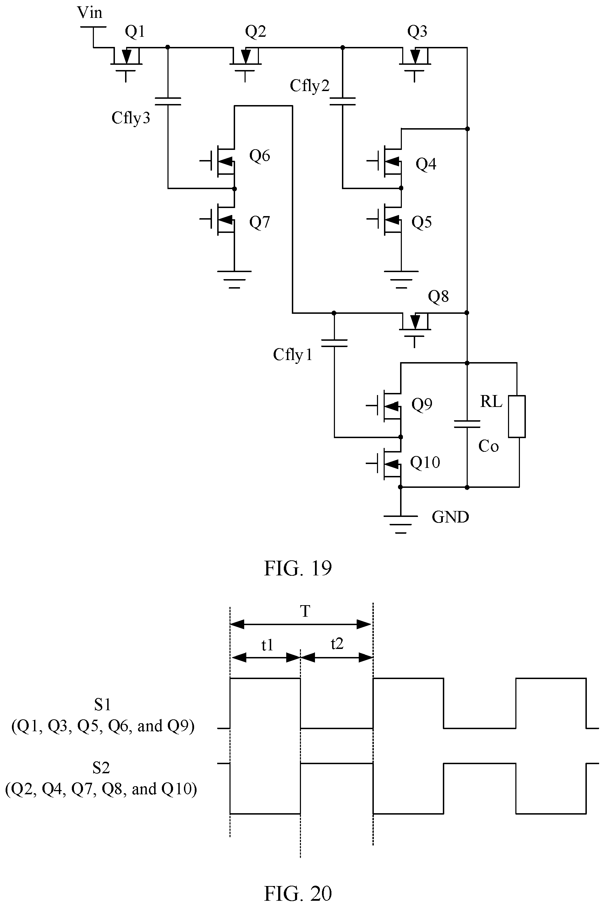

Refer to FIG. 19. Another typical Dickson (Dickson)-based SC is further provided. The SC includes ten switches: Q1 to Q10, and four capacitors: Cflyl, Cflyl, Cfly3, and Co. The switches Q1, Q2, Q3 and the capacitor Co are sequentially connected in series between a power supply end (providing a power supply voltage Vin) and a ground GND, a series connection structure of the switches Q4 and Q5 is connected in parallel to the capacitor Co, a series connection structure of the switches Q8, Q6, and Q7 is connected in parallel to the capacitor Co, a series connection structure of the switches Q9 and Q10 is connected in parallel to the capacitor Co, a series connection structure of the switches Q2, Q3, Q8, and Q6 is connected in parallel to the capacitor Cfly3, a series connection structure of the switches Q3 and Q4 is connected in parallel to the capacitor Cfly2, a series connection structure of the switches Q8 and Q9 is connected in parallel to the capacitor Cfly1, and a voltage output at two ends of the capacitor Co supplies power to a load RL.

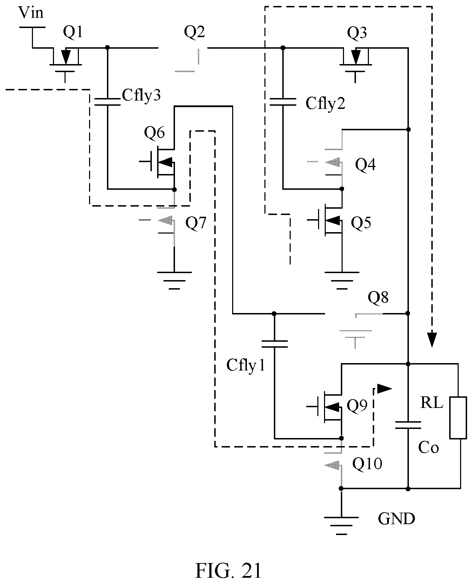

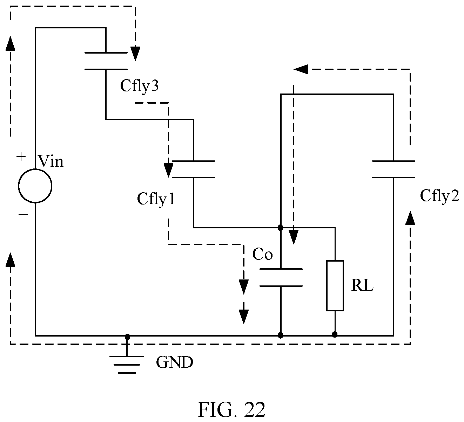

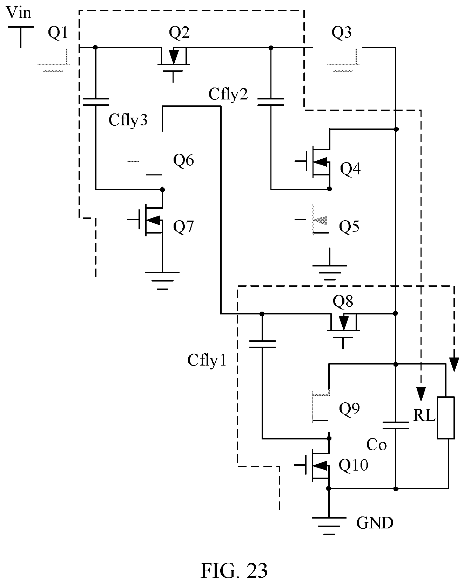

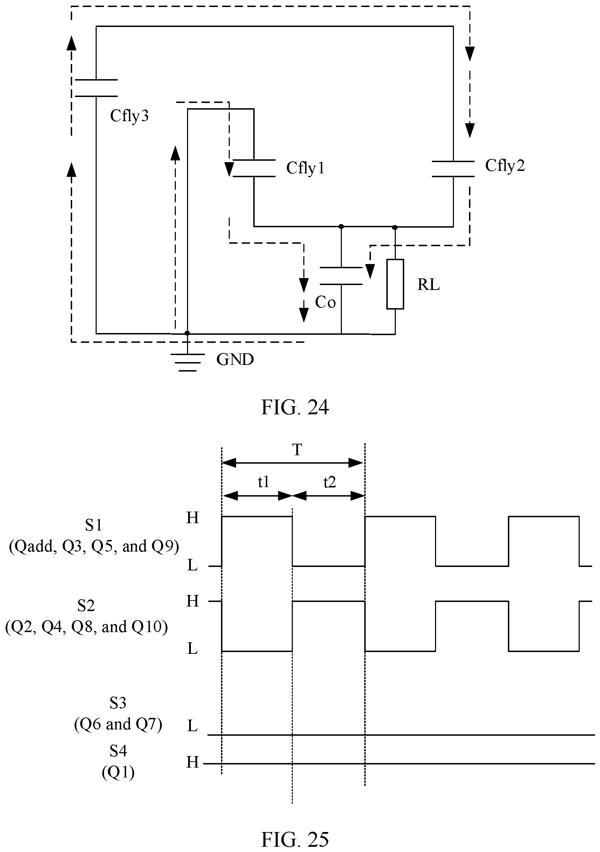

In addition, FIG. 20 is a time sequence diagram of control signals of the switches in FIG. 19 in one time periodicity T in a 4:1 voltage step-down mode. For example, each switch is turned on at a high level and is turned off at a low level. In a first time period t1 of one time periodicity T, as shown in FIG. 21, the switches Q1, Q3, Q5, Q6, and Q9 are in a turned-on state under control of S1, and the switches Q2, Q4, Q7, Q8, and Q10 are in a turned-off state under control of S2, so that the capacitors are connected to form an equivalent circuit shown in FIG. 22. The third capacitor Cfly3, the first capacitor Cfly1, and the fourth capacitor Co form a series structure, and two ends of the series structure are respectively connected to the power supply end and the ground end GND. The second capacitor Cfly2 and the fourth capacitor Co are connected in parallel. A current flow direction is shown by a dashed arrow in the figure. In this way, when the system is stable, Vin=Vcfly3+Vcfly1+Vo, and Vcfly2=Vo. In a second time period t2, as shown in FIG. 23, the switches Q1, Q3, Q5, Q6, and Q9 are in a turned-off state under control of S1, and the switches Q2, Q4, Q7, Q8, and Q10 are in a turned-on state under control of S2, so that the capacitors are connected to form an equivalent circuit shown in FIG. 24. The first capacitor Cfly1 and the fourth capacitor Co are connected in parallel. A serial connection structure of the second capacitor Cfly2 and the third capacitor Cfly3 is connected in parallel to the fourth capacitor Co. A current flow direction is shown by a dashed line arrow in the figure. In this way, when the system is stable, Vcfly3=Vcfly2+Vo, where Vcfly2 is a voltage at two ends of the capacitor Cfly2. In conclusion, it can be learned that Vin=4Vo, Vcfly3=2Vo, Vcfly2=Vo, and Vcfly1=Vo. Therefore, 4:1 voltage ratio conversion can be implemented.

With reference to circuit analysis of the SC provided in FIG. 9 in the 4:1 voltage step-down mode in FIG. 10 to FIG. 12 and circuit analysis of the SC provided in FIG. 19 in the 4:1 voltage step-down mode in FIG. 20 to FIG. 24, it can be learned that the SC provided in FIG. 9 in this embodiment of this application can at least implement effect equivalent to effect of the SC provided in FIG. 19 in the 4:1 voltage step-down mode.

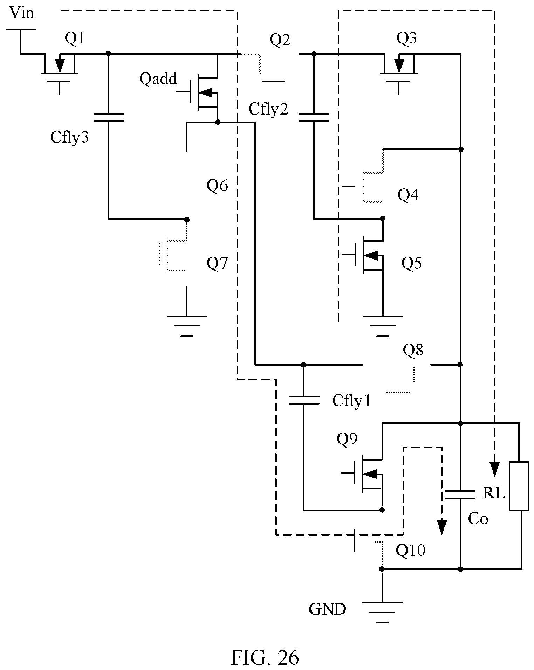

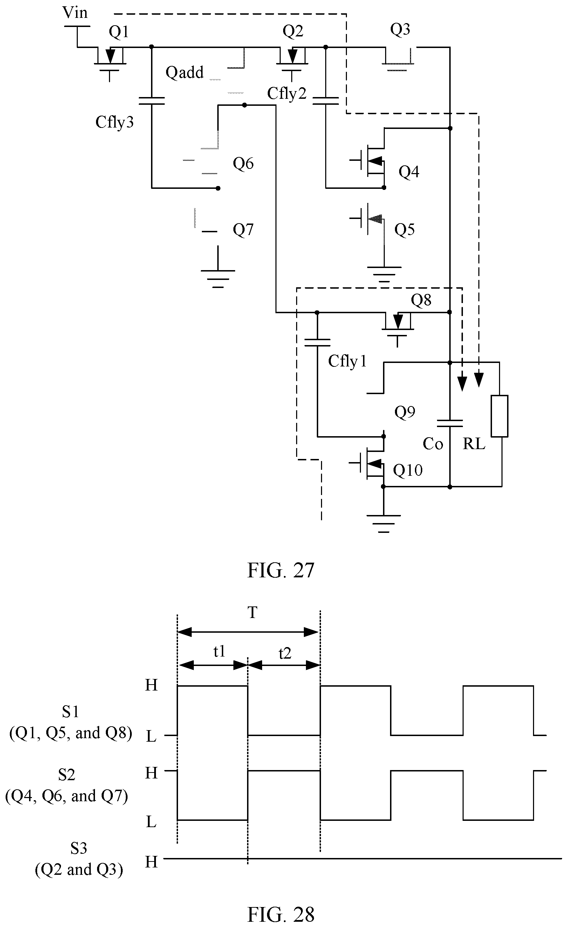

FIG. 25 is a time sequence diagram of control signals of the switches in FIG. 9 in one time periodicity T in a 2:1 voltage step-down mode. For example, each switch is turned on at a high level and is turned off at a low level. The switches Q6 and Q7 (under control of S3) are in a turned-off state in the entire time periodicity T, and Q1 (under control of S4) is in a turned-on state in the entire time periodicity T. In a first time period t1 of one time periodicity T, as shown in FIG. 26, the switches Qadd, Q3, Q5, and Q9 are in a turned-on state under control of S1, and the switches Q2, Q4, Q8, and Q10 are in a turned-off state under control of S2, so that the capacitors are connected to form an equivalent circuit shown in FIG. 6. In a second time period t2, as shown in FIG. 27, the switches Qadd, Q3, Q5, and Q9 are in a turned-off state under control of S1, and the switches Q2, Q4, Q8, and Q 10 are in a turned-on state under control of S2, so that the capacitors are connected to form an equivalent circuit shown in FIG. 7. Therefore, 2:1 voltage ratio conversion can be implemented.

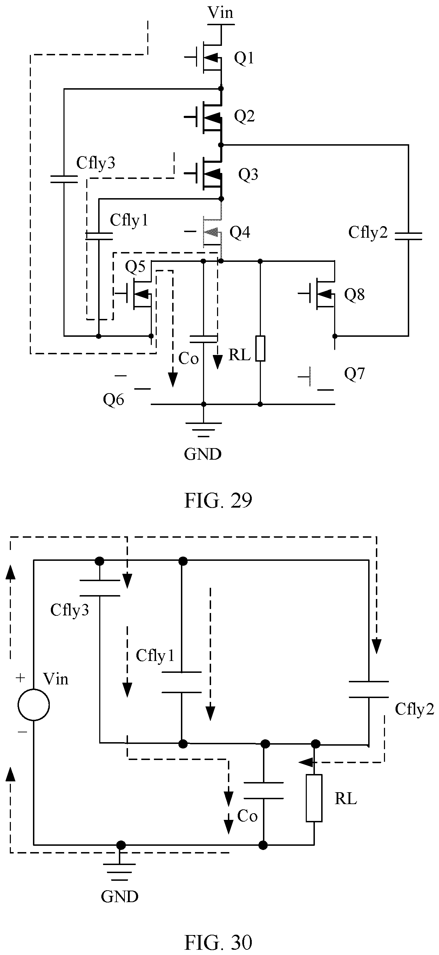

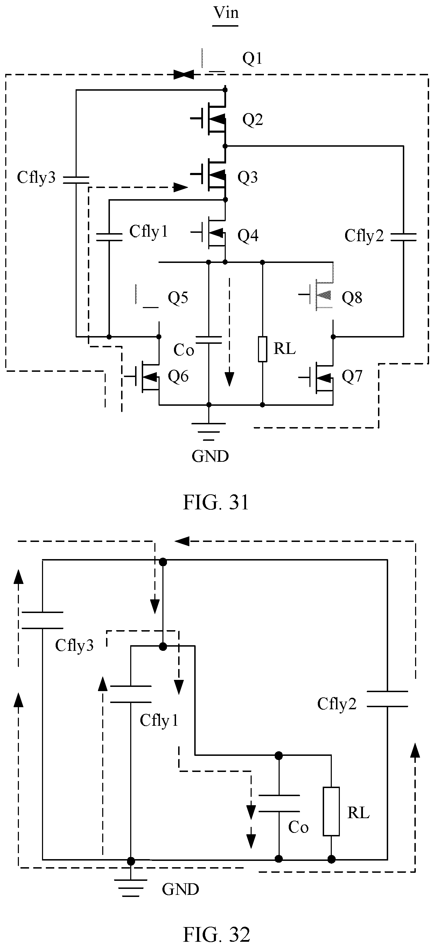

In addition, FIG. 28 is a time sequence diagram of control signals of the switches in FIG. 13 in one time periodicity T in a 2:1 voltage step-down mode. For example, each switch is turned on at a high level and is turned off at a low level. The switches Q2 and Q3 (under control of S3) are in a turned-on state in the entire time periodicity T. In a first time period t1 of one time periodicity T, as shown in FIG. 29, the switches Q1, Q5, and Q8 are in a turned-on state under control of S1, and the switches Q4, Q6, and Q7 are in a turned-off state under control of S2, so that the capacitors are connected to form an equivalent circuit shown in FIG. 30. The third capacitor Cfly3 and the fourth capacitor Co form a series structure, and two ends of the series structure are respectively connected to the power supply end and the ground end GND. The second capacitor Cfly2 and the fourth capacitor Co form a series structure, and two ends of the series structure are respectively connected to the power supply end and the ground end GND. The first capacitor Cfly1 and the fourth capacitor Co form a series structure, and two ends of the series structure are respectively connected to the power supply end and the ground end GND. A current flow direction is shown by a dashed arrow in the figure. In this way, when the system is stable, Vin=Vcfly1+Vo, and Vcfly1=Vcfly2=Vcfly3. In a second time period t2, as shown in FIG. 31, the switches Q1, Q5, and Q8 are in a turned-off state under control of S1, and the switches Q4, Q6, and Q7 are in a turned-on state under control of S2, so that the capacitors are connected to form an equivalent circuit shown in FIG. 32. The first capacitor Cfly1, the second capacitor Cfly2, and the third capacitor Cfly3 are all connected in parallel to the fourth capacitor Co. A current flow direction is shown by a dashed arrow in the figure. In this way, when the system is stable, Vcfly3=Vcfly2=cfly1=Vo. In conclusion, it can be learned that Vin=2Vo, Vcfly3=Vo, Vcfly2=Vo, and Vcfly1=Vo. Therefore, 2:1 voltage ratio conversion can be implemented.

With reference to circuit analysis of the SC provided in FIG. 9 in the 2:1 voltage step-down mode in FIG. 25 to FIG. 27 and circuit analysis of the SC provided in FIG. 13 in the 2:1 voltage step-down mode in FIG. 28 to FIG. 32, it can be learned that, in the 2:1 voltage step-down mode, because all currents of the SC provided in FIG. 13 need to pass through the switch Q5 (as shown in FIG. 29) in the time period t1 and all paths through which the currents flow need to pass through the switch Q6 (as shown in FIG. 31) in the time period t2, Q5 and Q6 have a larger current loss, and a large amount of heat is generated especially in a high current scenario, resulting in low efficiency. However, in the SC provided in FIG. 9, each switch passes through only one path through which a current flows. Therefore, losses of the currents on the switches are evenly distributed, and overall system efficiency is effectively improved compared with the SC provided in FIG. 13.

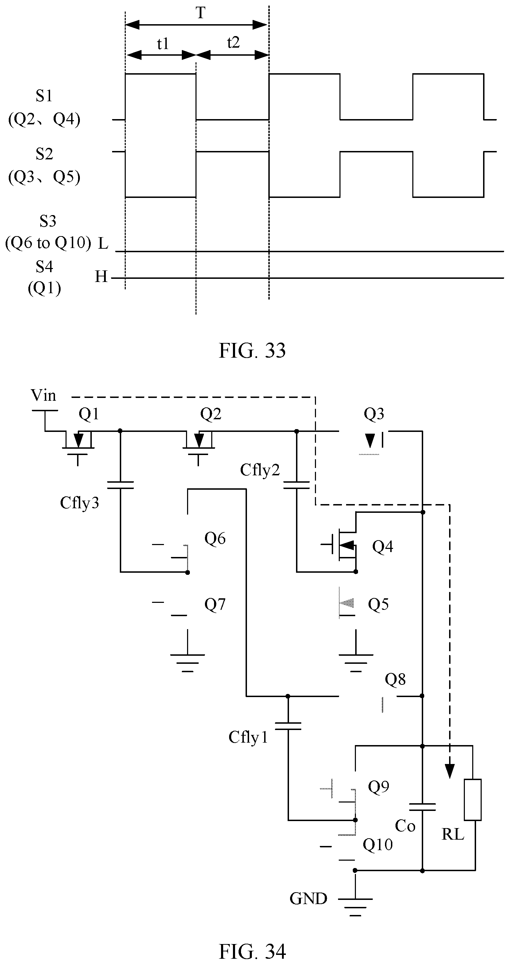

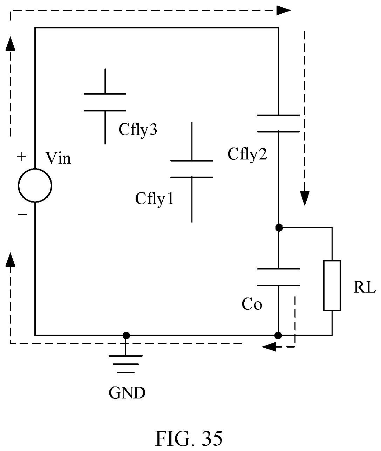

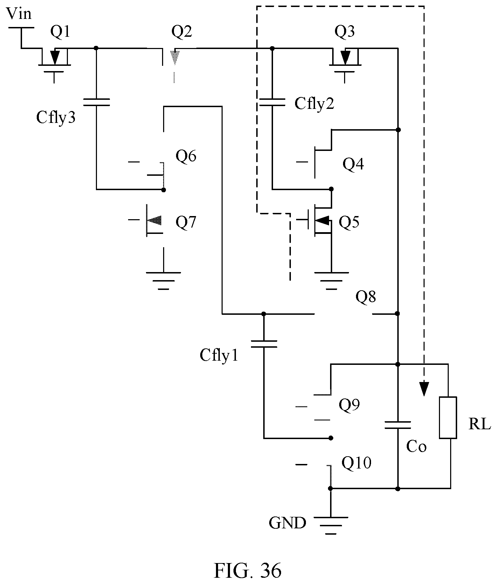

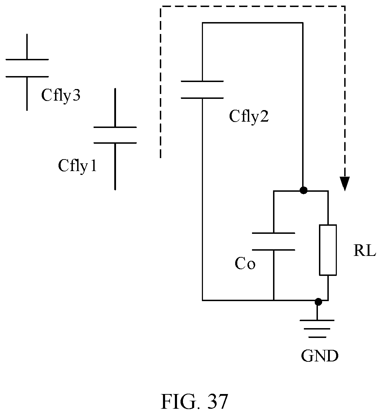

In addition, FIG. 33 is a time sequence diagram of control signals of the switches in FIG. 19 in one time periodicity T in a 2:1 voltage step-down mode. For example, each switch is turned on at a high level and is turned off at a low level. The switches Q6 to Q10 (under control of S3) are in a turned-off state in the entire time periodicity T, and Q1 (under control of S4) is in a turned-on state in the entire time periodicity T. In a first time period t1 of one time periodicity T, as shown in FIG. 34, the switches Q2 and Q4 are in a turned-on state under control of S1, and the switches Q3 and Q5 are in a turned-off state under control of S2, so that the capacitors are connected to form an equivalent circuit shown in FIG. 35. The third capacitor Cfly3 and the first capacitor Cfly1 are disconnected in the circuit. The second capacitor Cfly2 and the fourth capacitor Co form a series structure, and two ends of the series structure are respectively connected to the power supply end and the ground end GND. A current flow direction is shown by a dashed arrow in the figure. In this way, when the system is stable, Vin=Vcfly2+Vo. In a second time period t2, as shown in FIG. 36, the switches Q2 and Q4 are in a turned-off state under control of S1, and the switches Q3 and Q5 are in a turned-on state under control of S2, so that the capacitors are connected to form an equivalent circuit shown in FIG. 37. The third capacitor Cfly3 and the first capacitor Cfly1 are disconnected in the circuit. The second capacitor Cfly2 and the fourth capacitor Co are connected in parallel. A current flow direction is shown by a dashed line arrow in the figure. In this way, when the system is stable, Vcfly2=Vo. In conclusion, it can be learned that Vin=2Vo, and Vcfly2=Vo. Therefore, 2:1 voltage ratio conversion can be implemented.

With reference to circuit analysis of the SC provided in FIG. 9 in the 2:1 voltage step-down mode in FIG. 25 to FIG. 27 and circuit analysis of the SC provided in FIG. 19 in the 2:1 voltage step-down mode in FIG. 33 to FIG. 37, the SC provided in FIG. 19 uses only one flying capacitor Cfly2 in the 2:1 voltage step-down mode. In this structure, all currents provided by the power supply end have only one current path. However, the SC provided in FIG. 9 may use more flying capacitors (Cfly1 and Cfly2) in the 2:1 voltage step-down mode after one switch Qadd is added. In the time period t1, the capacitor Cfly1 is connected in series to the capacitor Co, and in the time period t2, the capacitor Cfly1 is connected in parallel to the capacitor Co, to form an interleaved parallel structure. This provides more current paths for the power supply end, and can effectively reduce power consumption compared with the solution provided in FIG. 19.

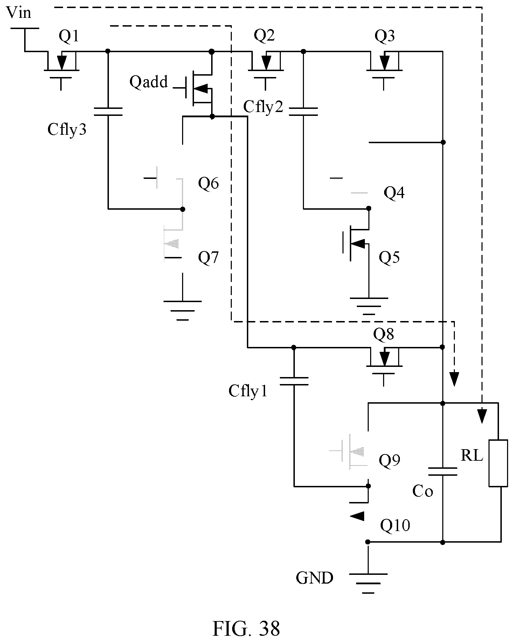

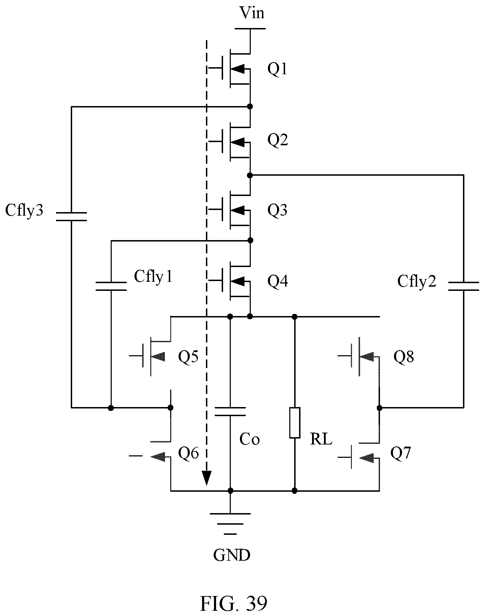

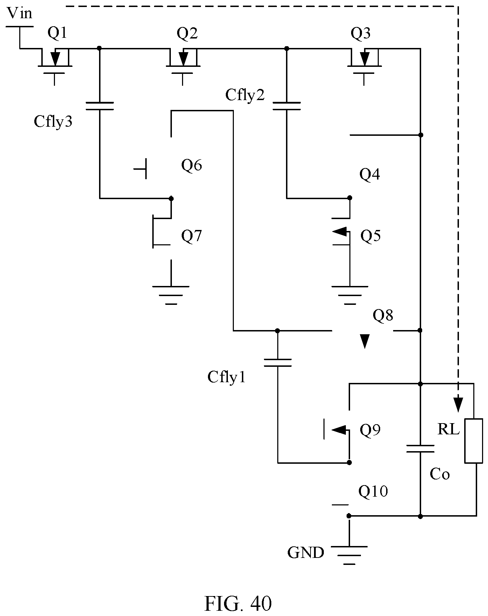

In a 1:1 voltage step-down mode, for the SC shown in FIG. 9, in the entire time periodicity, the switches Q1, Q2, Q3, Qadd, and Q8 are controlled to be turned on, and the other switches Q4 to Q7, Q9, and Q10 are controlled to be turned off, as shown in FIG. 38, so that the capacitors are connected to form the equivalent circuit shown in FIG. 8. Therefore, 1:1 voltage ratio conversion can be implemented. For the SC shown in FIG. 13, in the entire time periodicity, the switches Q1, Q2, Q3, and Q4 are controlled to be turned on, and the other switches Q5 to Q8 are controlled to be turned off, as shown in FIG. 39, so that the capacitors can be connected to form the equivalent circuit shown in FIG. 8. Therefore, 1:1 voltage ratio conversion can be implemented. For the SC shown in FIG. 19, in the entire time periodicity, the switches Q1, Q2, and Q3 are controlled to be turned on, and the other switches Q4 to Q10 and Qadd are controlled to be turned off, as shown in FIG. 40, so that the capacitors can be connected to form the equivalent circuit shown in FIG. 8. Therefore, 1:1 voltage ratio conversion can be implemented. The equivalent circuits in which the capacitors are connected in the SCs provided in FIG. 9, FIG. 13, and FIG. 19 in the 1:1 voltage step-down mode are the same. However, it can be learned from FIG. 38 to FIG. 40 that, in FIG. 38, because Qadd is added, when Q2, Q3, Qadd, and Q8 are turned on, a series connection structure of Q2 and Q3 and a series connection structure of Qadd and Q8 are connected in parallel, to reduce resistance on a current path; and the switches Q1, Q2, Q3, and Q4 on the current path in FIG. 39 are directly connected in series to the capacitor Co, and the switches Q1, Q2, and Q3 on the current path in FIG. 40 are directly connected in series to the capacitor Co. As a result, large resistance is provided. Therefore, the SC provided in FIG. 9 has higher efficiency.

In conclusion, the SC provided in FIG. 9 may implement a plurality of voltage step-down modes, including 4:1, 2:1, and 1:1, and has higher efficiency compared with two existing Dickson (Dickson)-based SCs (the SCs provided in FIG. 13 and FIG. 19).

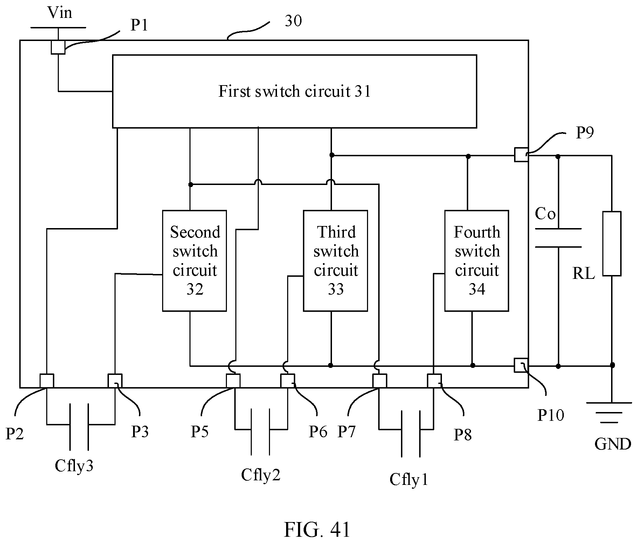

In addition, with reference to FIG. 41, a chip 30 is provided. The chip 30 includes a first switch circuit 31, a second switch circuit 32, a third switch circuit 33, and a fourth switch circuit 34. A difference from the SC circuit provided in FIG. 3 lies in that, because a capacitor needs to be implemented by using a large-sized polar plate, it is inconvenient to integrate the capacitor into a chip. Therefore, the SC provided in FIG. 3 may be formed by connecting the chip 30 provided in FIG. 41 and a capacitor disposed on a PCB outside the chip 30. Specifically, a package structure of the chip 30 provided in FIG. 41 includes: the first switch circuit 31, the second switch circuit 32, the third switch circuit 33, and the fourth switch circuit 34. The chip 30 further includes 10 chip pins (pin) in total from P1 to P10. A first end of the first switch circuit 31 is connected to a power supply end Vin through P1, a second end of the first switch circuit 31 is configured to connect to a first end of a third capacitor Cfly3 through P2, a third end of the first switch circuit 31 is connected to a first end of the second switch circuit 31, the third end of the first switch circuit 31 is further configured to connect to a first end of a first capacitor Cfly 1 through P7, a fourth end of the first switch circuit 31 is configured to connect to a first end of a second capacitor Cfly2 through P5, a fifth end of the first switch circuit 31 is connected to a first end of the third switch circuit 33 and a first end of the fourth switch circuit 34, and the fifth end of the first switch circuit 31 is further configured to connect to a first end of a fourth capacitor Co through P9. A second end of the second switch circuit 32 is configured to connect to a second end of the third capacitor Cfly3 through P3, and a third end of the second switch circuit 32 is connected to a ground GND through P10. A second end of the third switch circuit 33 is configured to connect to a second end of the second capacitor Cfly2 through P6, and a third end of the third switch circuit 33 is connected to the ground GND through P10. A second end of the fourth switch circuit 34 is configured to connect to a second end of the first capacitor Cfly1 through P8, and a third end of the fourth switch circuit 34 is connected to the ground GND through P10, and a second end of the fourth capacitor Co is connected to the ground GND. In addition, for internal structures and working principles of the first switch circuit 31, the second switch circuit 32, the third switch circuit 33, and the fourth switch circuit 34 in the chip, refer to detailed descriptions in the foregoing embodiments. The details are not described herein again.

Although this application is described with reference to the embodiments, in a process of implementing this application that claims protection, persons skilled in the art may understand and implement another variation of the disclosed embodiments by viewing the accompanying drawings, disclosed content, and the appended claims. In the claims, the word "comprising" does not exclude another component or another step, and "a" or "one" does not exclude a case of a plurality of objects. Some measures are recorded in dependent claims that are different from each other, but this does not mean that these measures cannot be combined to produce a better effect.

The foregoing has described the embodiments of this application. The foregoing descriptions are examples, not exhaustive, and are not limited to the disclosed embodiments. Many modifications and changes are apparent to those of ordinary skill in the art without departing from the scope and spirit of the illustrated embodiments. The selection of terms used in this specification is intended to best explain the principles of the embodiments, practical applications, or improvements to technologies in the market, or to enable other persons of ordinary skill in the art to understand the embodiments disclosed in this specification.

## Claims

1. A switched capacitor circuit SC, comprising: a first switch circuit, a second switch circuit, a third switch circuit, a fourth switch circuit, a first capacitor, a second capacitor, a third capacitor, and a fourth capacitor, wherein
a first end of the first switch circuit is connected to a power supply end, a second end of the first switch circuit is connected to a first end of the third capacitor, a third end of the first switch circuit is connected to a first end of the second switch circuit and a first end of the first capacitor, a fourth end of the first switch circuit is connected to a first end of the second capacitor, and a fifth end of the first switch circuit is connected to a first end of the third switch circuit, a first end of the fourth switch circuit, and a first end of the fourth capacitor; a second end of the third capacitor is connected to a second end of the second switch circuit, and a third end of the second switch circuit is connected to a ground; and a second end of the second capacitor is connected to a second end of the third switch circuit, a third end of the third switch circuit is connected to the ground, a second end of the first capacitor is connected to a second end of the fourth switch circuit, a third end of the fourth switch circuit is connected to the ground, and a second end of the fourth capacitor is connected to the ground;
in a first voltage step-down mode, the first switch circuit is configured to conduct the power supply end and the first end of the third capacitor and conduct the first end of the second capacitor and the first end of the fourth capacitor, the second switch circuit is configured to conduct the second end of the third capacitor and the first end of the first capacitor, the third switch circuit is configured to conduct the second end of the second capacitor and the ground, and the fourth switch circuit is configured to conduct the second end of the first capacitor and the first end of the fourth capacitor; or the first switch circuit is configured to conduct the first end of the third capacitor and the first end of the second capacitor and conduct the first end of the first capacitor and the first end of the fourth capacitor, the second switch circuit is configured to conduct the second end of the third capacitor and the ground, the third switch circuit is configured to conduct the second end of the second capacitor and the first end of the fourth capacitor, and the fourth switch circuit is configured to conduct the second end of the first capacitor and the ground;
in a second voltage step-down mode, the first switch circuit is configured to conduct the power supply end and the first end of the first capacitor and conduct the first end of the second capacitor and the first end of the fourth capacitor, the third switch circuit is configured to conduct the second end of the second capacitor and the ground, and the fourth switch circuit is configured to conduct the second end of the first capacitor and the first end of the fourth capacitor; or the first switch circuit is configured to conduct the first end of the second capacitor and the power supply end and conduct the first end of the first capacitor and the first end of the fourth capacitor, the third switch circuit is configured to conduct the second end of the second capacitor and the first end of the fourth capacitor, and the fourth switch circuit is configured to conduct the second end of the first capacitor and the ground; and
in a third voltage step-down mode, the first switch circuit is configured to conduct the power supply end and the first end of the fourth capacitor.

2. The SC according to claim 1, wherein the first switch circuit comprises: a first switch, a second switch, a third switch, a fourth switch, and a fifth switch, wherein a first end of the first switch is connected to the first end of the first switch circuit, and a second end of the first switch is connected to the second end of the first switch circuit; a first end of the second switch is connected to the second end of the first switch circuit, and a second end of the second switch is connected to the fourth end of the first switch circuit; a first end of the fourth switch is connected to the second end of the first switch circuit, and a second end of the fourth switch is connected to the third end of the first switch circuit; a first end of the third switch is connected to the fourth end of the first switch circuit, and a second end of the third switch is connected to the fifth end of the first switch circuit; and a first end of the fifth switch is connected to the third end of the first switch circuit, and a second end of the fifth switch is connected to the fifth end of the first switch circuit;
in the first voltage step-down mode, in a first time period of one periodicity, the first switch and the third switch are in a turned-on state, and the second switch and the fifth switch are in a turned-off state; in a second time period of one periodicity, the first switch and the third switch are in a turned-off state, and the second switch and the fifth switch are in a turned-on state; and the fourth switch is in a turned-off state in one periodicity;
in the second voltage step-down mode, in a first time period of one periodicity, the third switch and the fourth switch are in a turned-on state, and the second switch and the fifth switch are in a turned-off state; in a second time period of one periodicity, the third switch and the fourth switch are in a turned-off state, and the second switch and the fifth switch are in a turned-on state; the fourth switch is in a turned-off state in one periodicity; and the first switch is in a turned-on state in one periodicity; and
in the third voltage step-down mode, the first switch, the second switch, the third switch, the fourth switch, and the fifth switch are in a turned-on state.

3. The SC according to claim 1 or 2, wherein the second switch circuit comprises a sixth switch and a seventh switch, wherein a first end of the sixth switch is connected to the first end of the second switch circuit, and a second end of the sixth switch is connected to the second end of the second switch circuit; and a first end of the seventh switch is connected to the second end of the second switch circuit, and a second end of the seventh switch is connected to the third end of the second switch circuit;
in the first voltage step-down mode, in the first time period of one periodicity, the sixth switch is in a turned-on state, and the seventh switch is in a turned-off state; and in the second time period of one periodicity, the sixth switch is in a turned-off state, and the seventh switch is in a turned-on state;
in the second voltage step-down mode, the sixth switch and the seventh switch are in a turned-off state; and
in the third voltage step-down mode, the sixth switch and the seventh switch are in a turned-off state.

4. The SC according to any one of claims 1 to 3, wherein the third switch circuit comprises an eighth switch and a ninth switch, wherein
a first end of the eighth switch is connected to the first end of the third switch circuit, and a second end of the eighth switch is connected to the second end of the third switch circuit; and a first end of the ninth switch is connected to the second end of the third switch circuit, and a second end of the ninth switch is connected to the third end of the third switch circuit;
in the first voltage step-down mode, in the first time period of one periodicity, the ninth switch is in a turned-on state, and the eighth switch is in a turned-off state; and in the second time period of one periodicity, the ninth switch is in a turned-off state, and the eighth switch is in a turned-on state;
in the second voltage step-down mode, in the first time period of one periodicity, the ninth switch is in a turned-on state, and the eighth switch is in a turned-off state; and in the second time period of one periodicity, the ninth switch is in a turned-off state, and the eighth switch is in a turned-on state; and
in the third voltage step-down mode, the eighth switch and the ninth switch are in a turned-off state.

5. The SC according to any one of claims 1 to 4, wherein the fourth switch circuit comprises a tenth switch and an eleventh switch, wherein a first end of the tenth switch is connected to the first end of the fourth switch circuit, and a second end of the tenth switch is connected to the second end of the fourth switch circuit; and a first end of the eleventh switch is connected to the second end of the fourth switch circuit, and a second end of the eleventh switch is connected to the third end of the fourth switch circuit;
in the first voltage step-down mode, in the first time period of one periodicity, the tenth switch is in a turned-on state, and the eleventh switch is in a turned-off state; and in the second time period of one periodicity, the tenth switch is in a turned-off state, and the eleventh switch is in a turned-on state;
in the second voltage step-down mode, in the first time period of one periodicity, the tenth switch is in a turned-on state, and the eleventh switch is in a turned-off state; and in the second time period of one periodicity, the tenth switch is in a turned-off state, and the eleventh switch is in a turned-on state; and
in the third voltage step-down mode, the tenth switch and the eleventh switch are in a turned-off state.

6. The SC according to any one of claims 2 to 5, wherein each switch comprises one switch transistor, or each switch comprises two or more switch transistors connected in parallel.

7. A chip, comprising: a first switch circuit, a second switch circuit, a third switch circuit, and a fourth switch circuit, wherein
a first end of the first switch circuit is connected to a power supply end, a second end of the first switch circuit is configured to connect to a first end of a third capacitor, a third end of the first switch circuit is connected to a first end of the second switch circuit, the third end of the first switch circuit is further configured to connect to a first end of a first capacitor, a fourth end of the first switch circuit is configured to connect to a first end of a second capacitor, a fifth end of the first switch circuit is connected to a first end of the third switch circuit and a first end of the fourth switch circuit, and the fifth end of the first switch circuit is further configured to connect to a first end of a fourth capacitor; a second end of the second switch circuit is configured to connect to a second end of the third capacitor, and a third end of the second switch circuit is connected to a ground; a second end of the third switch circuit is configured to connect to a second end of the second capacitor, and a third end of the third switch circuit is connected to the ground; and a second end of the fourth switch circuit is configured to connect to a second end of the first capacitor, a third end of the fourth switch circuit is connected to the ground, and a second end of the fourth capacitor is connected to the ground;
in a first voltage step-down mode, the first switch circuit is configured to conduct the power supply end and the first end of the third capacitor and conduct the first end of the second capacitor and the first end of the fourth capacitor, the second switch circuit is configured to conduct the second end of the third capacitor and the first end of the first capacitor, the third switch circuit is configured to conduct the second end of the second capacitor and the ground, and the fourth switch circuit is configured to conduct the second end of the first capacitor and the first end of the fourth capacitor; or the first switch circuit is configured to conduct the first end of the third capacitor and the first end of the second capacitor and conduct the first end of the first capacitor and the first end of the fourth capacitor, the second switch circuit is configured to conduct the second end of the third capacitor and the ground, the third switch circuit is configured to conduct the second end of the second capacitor and the first end of the fourth capacitor, and the fourth switch circuit is configured to conduct the second end of the first capacitor and the ground;
in a second voltage step-down mode, the first switch circuit is configured to conduct the power supply end and the first end of the first capacitor and conduct the first end of the second capacitor and the first end of the fourth capacitor, the third switch circuit is configured to conduct the second end of the second capacitor and the ground, and the fourth switch circuit is configured to conduct the second end of the first capacitor and the first end of the fourth capacitor; or the first switch circuit is configured to conduct the first end of the second capacitor and the power supply end and conduct the first end of the first capacitor and the first end of the fourth capacitor, the third switch circuit is configured to conduct the second end of the second capacitor and the first end of the fourth capacitor, and the fourth switch circuit is configured to conduct the second end of the first capacitor and the ground; and
in a third voltage step-down mode, the first switch circuit is configured to conduct the power supply end and the first end of the fourth capacitor.

8. The chip according to claim 7, wherein the first switch circuit comprises: a first switch, a second switch, a third switch, a fourth switch, and a fifth switch, wherein a first end of the first switch is connected to the first end of the first switch circuit, and a second end of the first switch is connected to the second end of the first switch circuit; a first end of the second switch is connected to the second end of the first switch circuit, and a second end of the second switch is connected to the fourth end of the first switch circuit; a first end of the fourth switch is connected to the second end of the first switch circuit, and a second end of the fourth switch is connected to the third end of the first switch circuit; a first end of the third switch is connected to the fourth end of the first switch circuit, and a second end of the third switch is connected to the fifth end of the first switch circuit; and a first end of the fifth switch is connected to the third end of the first switch circuit, and a second end of the fifth switch is connected to the fifth end of the first switch circuit;
in the first voltage step-down mode, in a first time period of one periodicity, the first switch and the third switch are in a turned-on state, and the second switch and the fifth switch are in a turned-off state; in a second time period of one periodicity, the first switch and the third switch are in a turned-off state, and the second switch and the fifth switch are in a turned-on state; and the fourth switch is in a turned-off state in one periodicity;
in the second voltage step-down mode, in a first time period of one periodicity, the third switch and the fourth switch are in a turned-on state, and the second switch and the fifth switch are in a turned-off state; in a second time period of one periodicity, the third switch and the fourth switch are in a turned-off state, and the second switch and the fifth switch are in a turned-on state; the fourth switch is in a turned-off state in one periodicity; and the first switch is in a turned-on state in one periodicity; and
in the third voltage step-down mode, the first switch, the second switch, the third switch, the fourth switch, and the fifth switch are in a turned-on state.

9. The chip according to claim 7 or 8, wherein the second switch circuit comprises a sixth switch and a seventh switch, wherein a first end of the sixth switch is connected to the first end of the second switch circuit, and a second end of the sixth switch is connected to the second end of the second switch circuit; and a first end of the seventh switch is connected to the second end of the second switch circuit, and a second end of the seventh switch is connected to the third end of the second switch circuit;
in the first voltage step-down mode, in the first time period of one periodicity, the sixth switch is in a turned-on state, and the seventh switch is in a turned-off state; and in the second time period of one periodicity, the sixth switch is in a turned-off state, and the seventh switch is in a turned-on state;
in the second voltage step-down mode, the sixth switch and the seventh switch are in a turned-off state; and
in the third voltage step-down mode, the sixth switch and the seventh switch are in a turned-off state.

10. The chip according to any one of claims 7 to 9, wherein the third switch circuit comprises an eighth switch and a ninth switch, wherein
a first end of the eighth switch is connected to the first end of the third switch circuit, and a second end of the eighth switch is connected to the second end of the third switch circuit; and a first end of the ninth switch is connected to the second end of the third switch circuit, and a second end of the ninth switch is connected to the third end of the third switch circuit;
in the first voltage step-down mode, in the first time period of one periodicity, the ninth switch is in a turned-on state, and the eighth switch is in a turned-off state; and in the second time period of one periodicity, the ninth switch is in a turned-off state, and the eighth switch is in a turned-on state;
in the second voltage step-down mode, in the first time period of one periodicity, the ninth switch is in a turned-on state, and the eighth switch is in a turned-off state; and in the second time period of one periodicity, the ninth switch is in a turned-off state, and the eighth switch is in a turned-on state; and
in the third voltage step-down mode, the eighth switch and the ninth switch are in a turned-off state.

11. The chip according to any one of claims 7 to 10, wherein the fourth switch circuit comprises a tenth switch and an eleventh switch, wherein a first end of the tenth switch is connected to the first end of the fourth switch circuit, and a second end of the tenth switch is connected to the second end of the fourth switch circuit; and a first end of the eleventh switch is connected to the second end of the fourth switch circuit, and a second end of the eleventh switch is connected to the third end of the fourth switch circuit;
in the first voltage step-down mode, in the first time period of one periodicity, the tenth switch is in a turned-on state, and the eleventh switch is in a turned-off state; and in the second time period of one periodicity, the tenth switch is in a turned-off state, and the eleventh switch is in a turned-on state;
in the second voltage step-down mode, in the first time period of one periodicity, the tenth switch is in a turned-on state, and the eleventh switch is in a turned-off state; and in the second time period of one periodicity, the tenth switch is in a turned-off state, and the eleventh switch is in a turned-on state; and
in the third voltage step-down mode, the tenth switch and the eleventh switch are in a turned-off state.

12. The chip according to any one of claims 7 to 11, wherein each switch comprises one switch transistor, or each switch comprises two or more switch transistors connected in parallel.

13. An electronic device, comprising the SC according to any one of claims 1 to 6 or the chip according to claims 7 to 12.

14. The electronic device according to claim 13, further comprising a wireless charging coil, a receiver circuit, and a battery, wherein the wireless charging coil is connected to the receiver circuit, the receiver circuit is connected to a power supply end of the SC or the chip, and the battery is connected in parallel to the fourth capacitor.

15. The electronic device according to claim 13, further comprising a USB interface and a battery, wherein the USB interface is connected to a power supply end of the SC or the chip, and the battery is connected in parallel to the fourth capacitor.

16. The electronic device according to claim 15, wherein an over voltage protection circuit is further provided between the USB interface and the power supply end of the SC or the chip, and the over voltage protection circuit is configured to disconnect the power supply end of the SC or the chip from the USB interface when detecting that a voltage connected to the USB interface exceeds a threshold voltage.
